# EUROPEAN PATENT APPLICATION

(11) **EP 4 429 439 A2**
(43) Date of publication of application: **11.09.2024**
(21) Application number: 24153980.8
(22) Date of filing: 25.01.2024
(51) Int. Cl.: H10K 59/121, H10K 59/131

(54) **LIGHT EMITTING DISPLAY DEVICE**

(30) Priority: 06.03.2023 KR 20230029460
(71) Applicant: Samsung Display Co., Ltd., Yongin-si, Gyeonggi-do 17113 (KR)
(72) Inventor: Cho, Jae Hyung, Yongin-si, Gyeonggi-do (KR)
(74) Representative: Gulde & Partner

(57) **Abstract**

A light emitting display device according to an embodiment includes a display area (DA) that includes a plurality of pixel circuit portions (PC), a plurality of light emitting diodes (LED) electrically connected to the plurality of pixel circuit portions (PC), respectively, and a valley portion (VLY) that is disposed in the display area (DA), surrounds at least one of the plurality of pixel circuit portions (PC) to partition the plurality of pixel circuit portions (PC) into a plurality of regions, and includes at least one valley portion opening (VLYo).

## Description

### BACKGROUND

### 1. Field

The present disclosure relates to a light emitting display device, and more particularly, it relates to a light emitting display device that includes a valley portion disposed in a display area and formed of an organic material.

### 2. Description of the Related Art

As a device displaying an image, a display device includes a liquid crystal display (LCD), an organic light emitting diode (OLED), and the like. Such a display device is used in various electronic devices such as portable phones, navigation devices, digital cameras, electronic books, portable game devices, or various terminals.

A display device such as an organic light emitting device may have a structure in which the display device can be bent or folded by using a flexible substrate.

### SUMMARY

Embodiments are to provide a light emitting display device with high resolution while being resistant to external impact.

A light emitting display device according to an embodiment includes a display area, the display area comprising: a plurality of pixel circuit portions, a plurality of light emitting diodes electrically connected to the plurality of pixel circuit portions, respectively, and a valley portion that is disposed in the display area, surrounds at least one of the plurality of pixel circuit portions to partition the plurality of pixel circuit portions into a plurality of regions, and includes at least one valley portion opening.

Each of the plurality of pixel circuit portions may include a plurality of conductive layers, a semiconductor layer, and a plurality of insulating layers, and the valley portion may be a portion of the plurality of insulating layers in which at least one of the plurality of insulating layers may be removed and filled with an organic material.

The plurality of light emitting diodes may be disposed on the plurality of pixel circuit portions.

The valley portion may include a first portion extending in a first direction and a second portion extending in a second direction, and the at least one of valley portion opening may be disposed in the second portion.

The at least one valley portion opening disposed in the second portion may be formed in a plurality, and at least two valley portion openings may be disposed on a line extending along the first direction.

The at least one valley portion opening disposed in the second portion may be formed in a plurality, and valley portion openings disposed adjacent to each other along the first direction may not be disposed on a line extending along the first direction.

One second portion in the one region of the plurality of regions may include one valley portion opening, and valley portion openings in adjacent second portions may be disposed in areas different from each other along the second direction.

Each of the plurality of pixel circuit portions may include a plurality of wirings, a plurality of transistors, and a storage capacitor, and at least one of the plurality of wirings directly connecting adjacent pixel circuit portions may be connected through the at least one valley portion opening.

The plurality of transistors included in the each of the plurality of pixel circuit portions may include a first transistor, a second transistor, a third transistor, a fourth transistor, a fifth transistor, and a sixth transistor, the plurality of wirings may include: a first scan line connected to a gate electrode of the second transistor; a second scan line connected to a gate electrode of the third transistor; an initialization control line connected to a gate electrode of the fourth transistor; and a light emission control line connected to a gate electrode of the fifth transistor and a gate electrode of the sixth transistor, wherein the at least one of the plurality of wirings directly connecting the adjacent pixel circuit portions through the at least one valley portion opening may be one of the first scan line, the second scan line, the initialization control line, and the light emission control line.

The valley portion may include a first portion extending in a first direction and a second portion extending in a second direction, the at least one valley portion opening may be formed in plurality in the second portion, and a valley portion opening through which first scan lines disposed adjacent to each other along the first direction is connected may be different from a valley portion opening through which light emission control line disposed adjacent to each other along the first direction is connected.

The second portion of the valley portion may further include valley portion openings through which second scan lines disposed adjacent to each other along the first direction and initialization control lines disposed adjacent to each other along the first direction are connected, respectively.

The second scan line may further include a lower second scan line connected to the second scan line and the initialization control line may further include a lower initialization control line electrically connected to the initialization control line, and the lower second scan line and the lower initialization control line may be also directly connected through the same valley portion opening with the second scan line and the initialization control line, respectively.

The first transistor, the second transistor, the fifth transistor, and the sixth transistor may include a polycrystalline semiconductor, and the third transistor and the fourth transistor may include an oxide semiconductor.

The light emitting display device may further include a metal layer that is provided in a lower portion of the first transistor and may overlap a channel of the first transistor, wherein the metal layer may extend while overlapping the valley portion.

The polycrystalline semiconductor included in the first transistor, the second transistor, the fifth transistor, and the sixth transistor may be formed as a first semiconductor layer, and the first semiconductor layer may include a portion formed in common with an adjacent first semiconductor layer.

The portion formed in common among the first semiconductor layer may overlap with the valley portion in a plan view.

A light emitting display device according to an embodiment includes a display area that includes a plurality of pixel circuit portions, a plurality of light emitting diodes electrically connected to the plurality of pixel circuit portions, respectively, and a valley portion that is disposed in the display area, surrounds at least one of the plurality of pixel circuit portions to partition the plurality of pixel circuit portions into a plurality of regions, and may include at least one concave groove having a width narrower than other portions of the valley portion, and the pixel circuit portion may be convexly protruded along the groove.

The pixel circuit portion may include a plurality of conductive layers, a semiconductor layer, and a plurality of insulating layers, and the valley portion may be a portion of the plurality of insulating layers in which at least one of the plurality of insulating layers is removed and filled with an organic material.

The valley portion may include a first portion extending in a first direction and a second portion extending in a second direction, and the groove may be disposed in the second portion.

The pixel circuit portion may include a plurality of wirings, a plurality of transistors, and a storage capacitor, and the pixel circuit portion may include a protrude portion convexly protruding along the groove, and a portion of at least one of the plurality of transistors or the storage capacitor may be disposed in the protrude portion.

According to the embodiments, the light emitting display device including a valley portion disposed within the display area and formed of an organic material may have a feature that is resistant to external impact. According to the embodiments, a light emitting display device having high resolution can be manufactured by forming an opening or groove in a portion of the valley portion such that the pixel area is reduced due to the valley portion.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

FIG. 1 is a top plan view of a part of a display area of a light emitting display device according to an embodiment.
FIG. 2 is a circuit diagram of a pixel included in the light emitting display device according to an embodiment.
FIG. 3, 4, 5, 6, 7, 8, 9, 10, 11, 12, 13, 14 and FIG. 15 specifically show the structure of each layer according to the manufacturing sequence of the lower panel layer among light emitting display devices according to an embodiment.
FIG. 16 is a cross-sectional view of the light emitting display device according to the embodiment.
FIG. 17, 18, 19, 20, 21, 22, 23 and FIG. 24 show a structure of each layer according to a manufacturing sequence of a lower panel layer of a light emitting display device according to a comparative example in detail.
FIG. 25 is a cross-sectional view of the light emitting display device according to the comparative example.
FIG. 26, 27, 28, 29, 30, 31, 32, 33, 34, 35, 36, 37 and FIG. 38 show a structure of each layer according to a manufacturing sequence of a lower panel layer of a light emitting display device according to another embodiment in detail.
FIG. 39 and FIG. 40 are cross-sectional views of a light emitting display device according to another embodiment.
FIG. 41, 42 and FIG. 43 are top plan views of a part of a display area of a light emitting display device according to another embodiment.

### DETAILED DESCRIPTION

Hereinafter, with reference to accompanying drawings, various embodiments will be described in detail and thus a person of an ordinary skill can easily practice them in the technical field to which the present invention belongs. The present invention may be embodied in many different forms and is not limited to the embodiments described herein.

In order to clearly explain the present invention, parts irrelevant to the description are omitted, and the same reference numerals are applied to the same or similar constituent elements throughout the specification.

In addition, since the size and thickness of each component shown in the drawing is arbitrarily shown for convenience of explanation, the present invention is not necessarily limited to the drawings. In the drawings, the thickness of layers, films, panels, regions, etc., are exaggerated for clarity. In addition, in the drawing, for convenience of explanation, the thickness of some layers and regions is exaggerated.

In addition, when a part such as a layer, film, region, plate, constituent element, and the like is described to be "on" or "above" another part, this includes not only a case that it is "directly on" the other part, but also a case that there is another part in the middle. In contrast, when an element is referred to as being "directly on" another element, there are no intervening elements present. Further, the word "on" a reference portion will be understood to mean disposed above or below the reference portion, and will not necessarily be understood to mean disposed "at an upper side" based on an opposite to gravity direction.

In addition, unless explicitly described to the contrary, the word "comprise", and variations such as "comprises" or "comprising", will be understood to imply the inclusion of stated elements but not the exclusion of any other elements.

Further, throughout the specification, the phrase "on a plane" or "in a plan view" means viewing a target portion from the top, and the phrase "on a cross-section" means viewing a cross-section formed by vertically cutting a target portion from the side.

Further, throughout the specification, when it is referred to as "connected", this does not only mean that two or more constituent elements are directly connected, but may mean that two or more constituent elements are indirectly connected through another constituent element, are physically connected, electrically connected, or are integrated even though two or more constituent elements are referred as different names depending on a location and a function.

In addition, in the entire specification, when parts such as wiring, layer, film, region, plate, constituent element, and the like are "extended in a first direction or second direction," this does not mean only a straight line shape extending in the corresponding direction but also means a structure that is generally extended along the first direction or second direction, while including a structure that is bent at one part, a zigzag structure, or a curved line structure.

In addition, electronic devices (for example, mobile phone, TV, monitor, laptop computer, etc.) including display devices and display panels described in the specification, or electronic devices display including devices and display panels manufactured by a manufacturing method described in the specification are not excluded from the scope of the present invention as defined by the appended claims.

Hereinafter, among display areas of a light emitting display device, a structure of a display area that includes a valley portion surrounding a pixel circuit and formed of an organic material will be described.

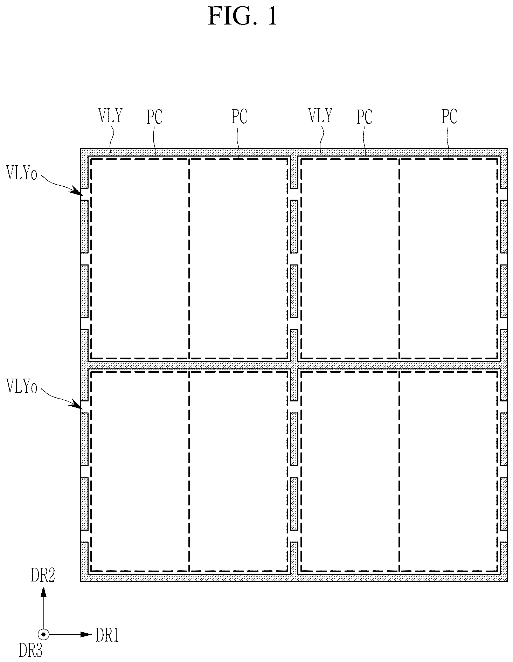

FIG. 1 is a top plan view of a part of a display area of a light emitting display device according to an embodiment.

FIG. 1 shows eight pixel circuit portions PC in the display area. A valley portion VLY surrounding the periphery of the pixel circuit portions PC is formed in each two pixel circuit portions PC along the first direction and each one pixel circuit portion PC along the second direction.

Specifically, the light emitting display device includes the display area illustrated in FIG. 1. A plurality of pixel circuit portions PC and a plurality of light emitting diodes that are electrically connected to the plurality of pixel circuit portions PC, respectively, are included in the display area. The valley portion VLY in the display area divides a plurality of pixel circuit portions PC into a plurality of regions, and includes at least one valley portion opening VLYo.

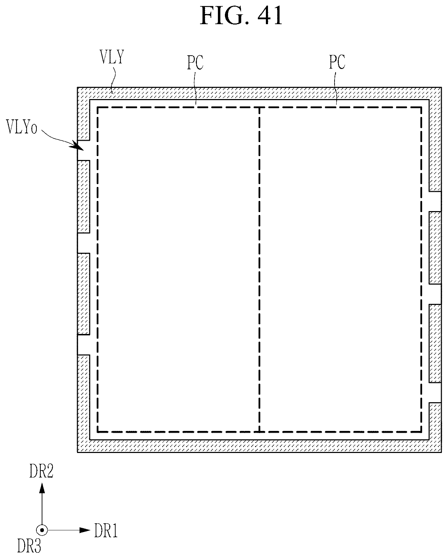

Specifically, the valley portion VLY includes a first portion extending in a first direction DR1 and a second portion extending in a second direction DR2. The valley portion opening VLYo is formed in the second portion extending in the second direction DR2. In the embodiment of FIG. 1, three valley portion openings VLYo are formed in an area corresponding to one pixel circuit portion PC in the second direction. The number of valley portion opening VLYo may vary according to embodiments. In the embodiment of FIG. 1, a plurality of valley portion openings VLYo are disposed in the second portion of the valley portion VLY, and the positions of the plurality of valley portion openings VLYo are the same in the second portion. For example, the valley portion openings VLYo in one row of the pixels may be disposed on a line extending along the first direction DR1. The position of the valley portion opening VLYo may be modified in various ways, and some of the modified structures thereof will be described later with reference to FIG. 41 to FIG 43.

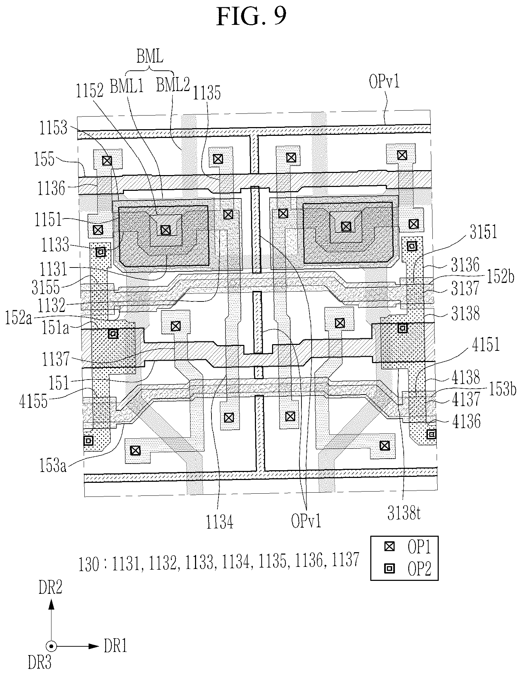

The valley portion VLY is formed by filling an organic material in a lower layer opening (refer to OPv1 in FIG. 9) which is formed by successively removing some insulating layers from among the plurality of insulation layers.

The valley portion opening VLYo may have a structure in which wiring (for example, a scan line, a control line, or a voltage line) extending in the first direction DR1 may be disposed and the wiring is easily connected to a plurality of pixel circuit portions PC in the first direction DR1 through the valley portion opening VLYo. In an embodiment described later, a pixel circuit portion PC includes a plurality of wiring, a plurality of transistors, and a storage capacitor, and at least one of the plurality of wires may be directly connected to another adjacent pixel circuit portion through the valley portion opening VLYo. Here, the wiring directly connected through the valley portion opening VLYo may be at least one of a first scan line, a second scan line, an initialization control line, and a light emitting control line. When all of the first scan line, the second scan line, the initialization control line, and the light emission control line are directly connected through the valley portion opening VLYo, each line may have a structure in which it is directly connected through a different valley portion opening VLYo. The wiring directly connected through the valley portion opening VLYo may vary depending on embodiments.

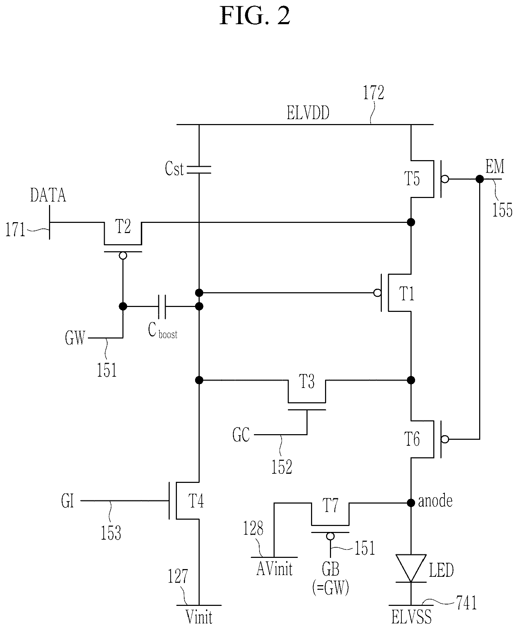

Each pixel circuit portion PC is connected to each light emitting diode LED (refer to LED in FIG. 2), and one pixel may include one pixel circuit portion PC and one light emitting diode LED. In FIG. 1, the light emitting diode LED is not shown separately because the light emitting diode LED is disposed above the pixel circuit portion PC and valley portion VLY in the third direction DR3. The light emitting diode LED is formed to overlap the pixel circuit portion PC in a plan view, and may be formed to overlap a part of the valley portion VLY.

The valley portion VLY may be formed by removing at least one insulation layer formed in the pixel circuit portion PC, for example, at least one inorganic insulation layer, and then forming an organic insulation material filling the removed portion of the at least one inorganic insulating layer. A cross-sectional structure of the valley portion VLY may be modified in various ways.

The valley portion VLY improves the impact characteristic of the display area of the light emitting display device, and thus even when a touch pen falls on the display area or a user strongly touches the display area, pixels disposed in the display area are not damaged. In the embodiment of FIG. 1, the valley portion VLY is disposed to surround the plurality of pixel circuit portions PC except in the valley portion openings VLYo which are disconnected portions of the valley portion VLY. Because the valley portion VLY is formed to surround most of the periphery of the plurality of pixel circuit portions PC, the display area of the light emitting display device may have enough resistance to the impact from outside.

A light emitting display device including a plurality of pixel circuit portions PC and a light emitting diodes LED and including a valley portion VLY in a display area may have at least a flexible portion, and may be folded in the flexible portion. That is, the light emitting display device may include a foldable region that is flexible and can be folded, and a non-folding region provided on at least one side of the foldable region and not folded. Here, in the embodiment, an area that is not folded is referred to as a non-folding region, but this is for convenience of description, and the expression "non-folding" includes not only a hard case without flexible, but also a case with flexible but have smaller flexibility than a foldable region, and a case with flexible but not folded. The light emitting display device may display an image in a display area of foldable region and non-foldable region. On the other hand, depending on embodiments, the light emitting display device may have a non-foldable structure because it does not have a flexible structure.

Depending on embodiments, a light emitting display device may have a peripheral area outside of the display area. The peripheral area may be a non-display area that surrounds the display area and does not have pixels. In the peripheral area, various electronic devices or printed circuit boards (PCBs) may be electrically attached, and voltage lines that supply power to drive pixels may be disposed. For example, in the peripheral area, a scan driver that provides a scan signal to each pixel, a data driver that provides a data signal to each pixel, supply lines of signals input to the scan driver and the data driver (clock signal line, carry signal line, driving voltage line, and the line), and main power lines may be disposed.

Hereinafter, a circuit structure of a pixel according to an embodiment will be described with reference to FIG. 2.

FIG. 2 is a circuit diagram of a pixel included in the light emitting display device according to an embodiment.

A pixel according to an embodiment includes a plurality of transistors T1, T2, T3, T4, T5, T6, and T7 connected to a plurality of wires 127, 128, 151, 152, 153, 155, 171, 172, and 741, a storage capacitor Cst, a boost capacitor C_{boost}, and a light emitting diode LED. Here, the transistor and capacitor except for the light emitting diode LED form the pixel circuit portion (refer to PC in FIG. 1). Depending on embodiments, the boost capacitor C_{boost} may be omitted.

A plurality of wires 127, 128, 151, 152, 153, 155, 171, 172, and 741 are connected to one pixel PX. The plurality of wires include a first initialization voltage line 127, a second initialization voltage line 128, a first scan line 151, a second scan line 152, an initialization control line 153, a light emission control line 155, a data line 171, a driving voltage line 172, and a common voltage line 741.

The first scan line 151 is connected to a scan driver (not shown) and transmits the first scan signal GW to the second transistor T2 and the seventh transistor T7. A voltage of opposite polarity to the voltage applied to the first scan line 151 may be applied to the second scan line 152 at the same timing as the signal of the first scan line 151. For example, when a voltage of negative polarity is applied to the first scan line 151, a voltage of positive polarity may be applied to the second scan line 152. The second scan line 152 transmits a second scan signal GC to the third transistor T3. The initialization control line 153 transmits the initialization control signal GI to the fourth transistor T4. The light emission control line 155 transmits a light emission control signal EM to the fifth transistor T5 and the sixth transistor T6.

The data line 171 is a wiring that transmits data voltage DATA generated by a data driver (not shown), and accordingly, the intensity of the light emitting current transmitted to the light emitting diode LED changes and the luminance emitted by the light emitting diode LED also changes. A driving voltage line 172 applies a driving voltage ELVDD. The first initialization voltage line 127 transmits a first initialization voltage Vinit, and the second initialization voltage line 128 transmits a second initialization voltage AVinit. The common voltage line 741 applies a common voltage ELVSS to a cathode of the light emitting diode LED. In the present embodiment, voltages applied to the driving voltage line 172, the first and second initialization voltage lines 127 and 128, and the common voltage line 741 may be constant voltages.

The driving transistor T1 (also referred to as first transistor) is a p-type transistor and has a silicon semiconductor as a semiconductor layer. The driving transistor adjusts the intensity of the light emitting current output to an anode of the light emitting diode LED according to the magnitude of a voltage of a gate electrode of the driving transistor T1 (i.e., a voltage stored in the storage capacitor Cst). Since the brightness of the light emitting diode LED is adjusted according to the intensity of the light emitting current output from the driving transistor T1, the light emitting luminance of the light emitting diode LED can be adjusted according to the data voltage DATA applied to the pixel. For this purpose, a first electrode of the driving transistor T1 is disposed to receive the driving voltage ELVDD, and is connected to the driving voltage line 172 via the fifth transistor T5. In addition, the first electrode of the driving transistor T1 is also connected to a second electrode of the second transistor T2 to receive the data voltage DATA. Meanwhile, the second electrode of the driving transistor T1 outputs the light emitting current to the light emitting diode LED, and is connected to the anode of the light emitting diode LED via the sixth transistor T6 (hereinafter referred to as an output control transistor). In addition, the second electrode of the driving transistor T1 is also connected to the third transistor T3, and transmits the data voltage DATA to the first electrode to the third transistor T3. Meanwhile, the gate electrode of the driving transistor T1 is connected to one electrode of the storage capacitor Cst (hereinafter referred to as a second storage electrode). Accordingly, the voltage of the gate electrode of the driving transistor T1 changes according to the voltage stored in the storage capacitor Cst, and the light emitting current output from the driving transistor T1 changes accordingly. The storage capacitor Cst serves to maintain the voltage of the gate electrode of the driving transistor T1 constant during one frame. Meanwhile, the gate electrode of the driving transistor T1 is also connected to the third transistor T3 such that the data voltage DATA applied to the first electrode of the driving transistor T1 is transmitted to the gate electrode of the driving transistor T1 via the third transistor T3. Meanwhile, the gate electrode of the driving transistor T1 is also connected to the fourth transistor T4 and can be initialized by receiving the first initialization voltage Vinit.

The second transistor T2 is a p-type transistor and has a silicon semiconductor as a semiconductor layer. The second transistor T2 is a transistor that transmit the data voltage DATA to the pixel. The gate electrode of the second transistor T2 is connected to the first scan line 151 and one electrode (hereinafter referred to as a lower boost electrode) of the boost capacitor C_{boost}. The first electrode of the second transistor T2 is connected to the data line 171. The second electrode of the second transistor T2 is connected to the first electrode of the driving transistor T1. When the second transistor T2 is turned on by the negative polarity voltage of the first scan signal GW transmitted through the first scan line 151, the data voltage DATA is transmitted to the first electrode of the driving transistor T1 through the turned-on second transistor T2, and the data voltage DATA is transmitted to the gate electrode of the driving transistor T1 through the third transistor T3 and stored in the storage capacitor Cst.

The third transistor T3 is an n-type transistor and has an oxide semiconductor as a semiconductor layer. The third transistor T3 electrically connects the second electrode of driving transistor T1 and the gate electrode of driving transistor T1. The third transistor T3 is a threshold voltage compensation transistor that compensates for a threshold voltage of the driving transistor T1. A gate electrode of the third transistor T3 is connected to the second scan line 152, and a first electrode of the third transistor T3 is connected to the second electrode of the driving transistor T1. A second electrode of the third transistor T3 is connected to the second storage electrode of the storage capacitor Cst, the gate electrode of the driving transistor T1, and the other electrode of the boost capacitor C_{boost} (hereinafter referred to as an upper boost electrode). The third transistor T3 is turned on by the positive voltage of the second scan signal GC transmitted through the second scan line 152, connects the gate electrode of the driving transistor T1 and the second electrode of the driving transistor T1, and stores a voltage applied to the gate electrode of the driving transistor T1 to the storage capacitor Cst by transmitting the voltage applied to the gate electrode of the driving transistor T1to the second storage electrode of the storage capacitor Cst. In this case, the voltage stored in the storage capacitor Cst is a voltage of the gate electrode of the driving transistor T1 when the driving transistor T1 is turned off such that the threshold voltage compensated data voltage may be stored in the storage capacitor Cst.

The fourth transistor T4 is an n-type transistor and has an oxide semiconductor as a semiconductor layer. The fourth transistor T4 serves to initialize the gate electrode of the driving transistor T1 and the second storage electrode of the storage capacitor Cst. A gate electrode of the fourth transistor T4 is connected to the initialization control line 153, and a first electrode of the fourth transistor T4 is connected to the first initialization voltage line 127. A second electrode of the fourth transistor T4 is connected to the second electrode of the third transistor T3, the second storage electrode of the storage capacitor Cst, the gate electrode of the driving transistor T1, and an upper boost electrode of the boost capacitor C_{boost}. The fourth transistor T4 is turned on by the voltage of the positive polarity among the initialization control signal GI transmitted through the initialization control line 153, and, in this case, the first initialization voltage Vinit is transmitted to the gate electrode of the driving transistor T1, the second storage electrode of the storage capacitor Cst, and the upper boost electrode of the boost capacitor C_{boost} for initialization.

The fifth transistor T5 and the sixth transistor T6 are p-type transistors and have a silicon semiconductor as a semiconductor layer.

The fifth transistor T5 serves to transmits the driving voltage ELVDD to the driving transistor T1. A gate electrode of the fifth transistor T5 is connected to the light emission control line 155, a first electrode of the fifth transistor T5 is connected to the driving voltage line 172, and a second electrode of the fifth transistor T5 is connected to the first electrode of the driving transistor T1.

The sixth transistor T6 serves to transmit the light emitting current output from the driving transistor T1 to the light emitting diode LED. The gate electrode of the sixth transistor T6 is connected to the light emission control line 155, the first electrode of the sixth transistor T6 is connected to the second electrode of the driving transistor T1, and the second electrode of the sixth transistor T6 is connected to the anode of the light emitting diode LED.

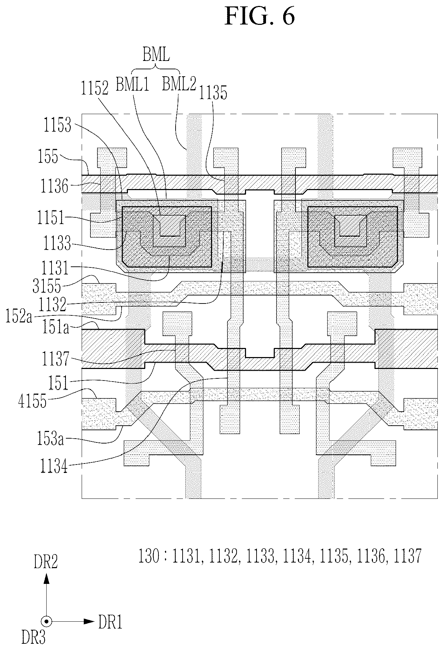

The seventh transistor T7 is a p-type or n-type transistor, and may have a silicon semiconductor or oxide semiconductor as a semiconductor layer, and in the embodiment of FIG. 6, the seventh transistor T7 is a p-type transistor and includes a silicon semiconductor. The seventh transistor T7 serves to initialize the anode of the light emitting diode LED. A gate electrode of the seventh transistor T7 is connected to the first scan line 151, a first electrode of the seventh transistor T7 is connected to the anode of the light emitting diode LED, and a second electrode of the seventh transistor T7 is connected to the second initialization voltage line 128. Here, the gate electrode of the seventh transistor T7 is connected to the first scan line 151 of the previous pixel, and is not connected to the same first scan line 151 to which the gate electrode of the second transistor T2 included in the same pixel PX is connected, but may be connected to the same first scan line 151 to which the gate electrode of the second transistor T2 of the previous pixel PX is connected. When the seventh transistor T7 is turned on by the negative polarity voltage of the first scan line 151 of the previous pixel, the second initialization voltage AVinit is applied to the anode of the light emitting diode LED for initialization. Meanwhile, the gate electrode of the seventh transistor T7 is connected to a separate bypass control line through which a bypass signal GB is transmitted, and may be controlled by separate wiring from the first scan line 151. In addition, depending on embodiments, the second initialization voltage line 128 to which the second initialization voltage AVinit is applied may be the same as the first initialization voltage line 127 to which the first initialization voltage Vinit is applied.

Although it has been described that one pixel PX includes seven transistors T1 to T7 and two capacitors (i.e., the storage capacitor Cst and the boost capacitor C_{boost}, it is not limited thereto, and depending on embodiments, the boost capacitor C_{boost} may be excluded. In addition, although the third transistor and the fourth transistor are formed of n-type transistors, only one of them may be formed of n-type transistors, or other transistors (e.g., the seventh transistor, etc.) may be formed of n-type transistors.

Hereinabove, the circuit structure of the pixel PX formed in the display area DA has been described with reference to FIG. 2.

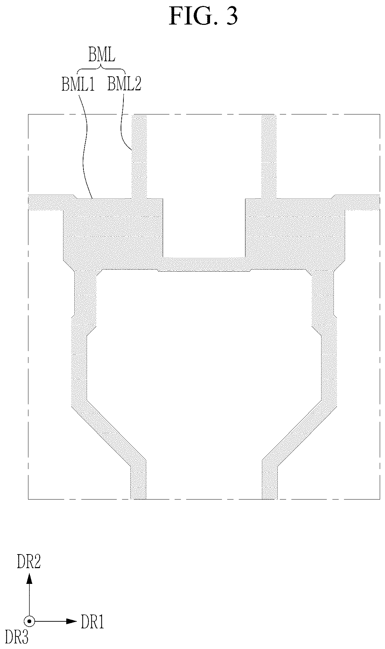

Hereinafter, referring to FIG. 3 to FIG. 16, a detailed planar structure and a stacking structure of the pixel PX formed in the display area DA according to an embodiment will be described.

First, referring to FIG. 3 to FIG. 15, a planar structure according to an embodiment will be described.

FIG. 3 to FIG. 15 specifically show the structure of each layer according to the manufacturing sequence of the lower panel layer among light emitting display devices according to an embodiment.

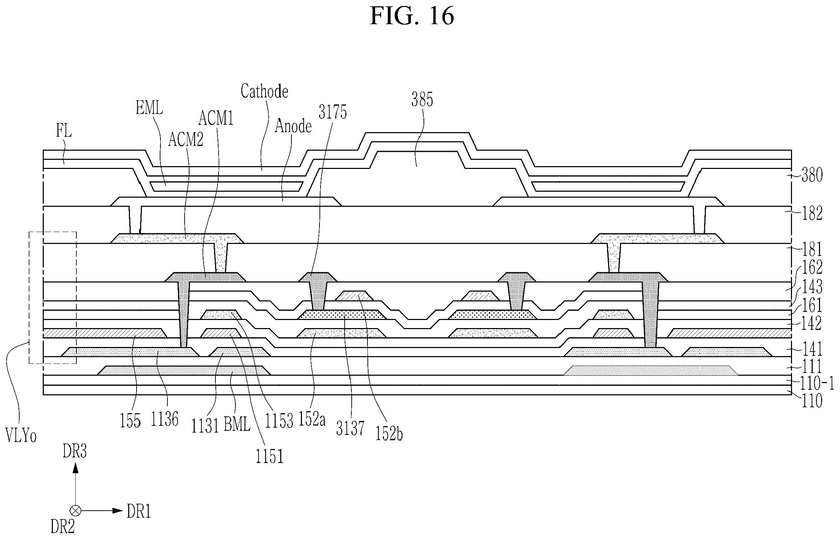

Referring to FIG. 3, a metal layer BML is disposed on a substrate 110 (refer to FIG. 16).

The substrate 110 may include a material that has a rigid characteristic such as glass and does not bend, or may include a flexible material that can bend such as plastic or polyimide. In the case of a flexible substrate, as shown in FIG. 16, a double-layer structure of polyimide and a barrier layer formed of an inorganic insulating material disposed on the polyimide (refer to 110-1 of FIG. 16) may be formed.

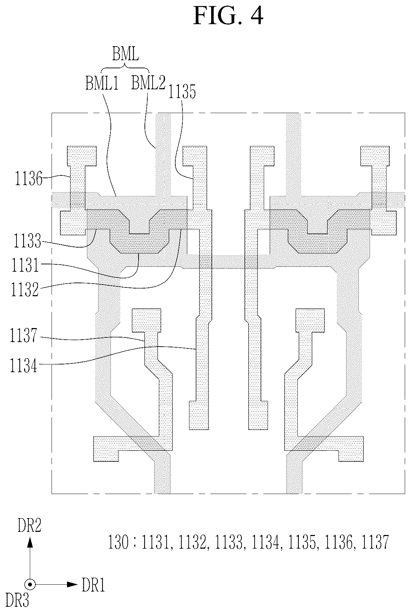

The metal layer BML includes a plurality of expansion portions BML1 and a connection portion BML2 connecting the plurality of expansion portions BML1 to each other. The expansion portion BML1 of the metal layer BML may be formed at a position overlapping a channel (refer to 1131 of FIG. 4) of the driving transistor T1 in a plan view. The metal layer BML is also called as a lower shielding layer, and may include a metal such as copper (Cu), molybdenum (Mo), aluminum (Al), and titanium (Ti) or metal alloys thereof, and may additionally include amorphous silicon and may be formed of a single layer or multiple layers.

Referring to FIG. 16, a buffer layer 111 covering the substrate 110 and the metal layer is disposed on the metal layer BML. The buffer layer 111 serves to block penetration of impurities into the first semiconductor layer 130 and may be an inorganic insulating layer including a silicon oxide (SiOₓ), a silicon nitride (SiNₓ), or a silicon oxynitride (SiOₓN_{y}).

As shown in FIG. 4, the first semiconductor layer 130 formed of a silicon semiconductor (e.g., a polycrystalline semiconductor) is disposed on the buffer layer 111. The first semiconductor layer 130 includes a channel 1131, a first region 1132, and a second region 1133 of the driving transistor T1. In addition, the first semiconductor layer 130 includes channels of not only the driving transistor T1 but also the second transistor T2, the fifth transistor T5, the sixth transistor T6, and the seventh transistor T7, and includes regions with conductivity by plasma treatment or doping on both sides of each channel, thereby serving as a first electrode and a second electrode.

The channel 1131 of the driving transistor T1 may be formed in a shape bent in a U shape in a plan view. However, the shape of the channel 1131 of the driving transistor T1 is not limited thereto and may be variously changed. For example, the channel 1131 of the driving transistor T1 may be bent in various other shapes such as an S shape or may be formed in a bar shape. The first region 1132 and the second region 1133 of the driving transistor T1 may be disposed on both sides of the channel 1131 of the driving transistor T1. The first region 1132 and the second region 1133 disposed on the first semiconductor layer serve as the first electrode and second electrode of the driving transistor T1.

In the first semiconductor layer 130, the channel, first region, and second region of the second transistor T2 are disposed in a portion 1134 extending downward from the first region 1132 of the driving transistor T1. In a portion 1135 extending upward from the first region 1132 of the driving transistor T1, the channel, the first region, and the second region of the fifth transistor T5 are disposed. In a portion 1136 extending upward from the second region 1133 of the driving transistor T1, a channel, a first region, and a second region of the sixth transistor T6 are disposed. In the first semiconductor layer 130, a channel, a first region, and a second region of the seventh transistor T7 are disposed in the portion 1137 formed in an island-like structure separated from the channel 1131 of the driving transistor T1.

Referring to FIG. 16, the first gate insulating layer 141 may be disposed on the first semiconductor layer 130 including the channel 1131, the first region 1132, and the second region 1133 of the driving transistor T1. The first gate insulating layer 141 may be an inorganic insulating layer including a silicon oxide (SiOₓ), a silicon nitride (SiNₓ), or a silicon oxynitride (SiOₓN_{y}).

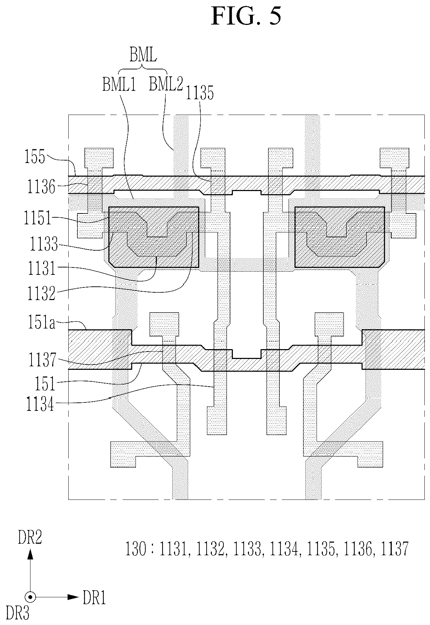

Referring to FIG. 5, a first gate conductive layer including the gate electrode 1151 of the driving transistor T1 may be disposed on the first gate insulating layer 141. The first gate conductive layer may include not only the gate electrode of the driving transistor T1, but also the gate electrodes of each of the second transistor T2, the fifth transistor T5, the sixth transistor T6, and the seventh transistor T7. The gate electrode 1151 of the driving transistor T1 may overlap the channel 1131 of the driving transistor T1. The channel 1131 of the driving transistor T1 is covered by the gate electrode 1151 of the driving transistor T1.

The first gate conductive layer may further include a first scan line 151 and a light emission control line 155. The first scan line 151 and the light emission control line 155 may extend in a substantially horizontal direction (hereinafter, also referred to as a first direction DR1). The first scan line 151 may be connected to the gate electrode of the second transistor T2, and the first scan line 151 may be integrally formed with the gate electrode of the second transistor T2. The first scan line 151 may be connected to a gate electrode of the seventh transistor T7 of the next pixel or integrally formed. The first scan line 151 may include a lower boost electrode 151a having an extended width, and the lower boost electrode 151a forms a boost capacitor C_{boost} with an upper boost electrode 3138t which overlaps the lower boost electrode 151a in a plan view and is described later.

Meanwhile, the light emission control line 155 may be connected to the gate electrode of the fifth transistor T5 and the gate electrode of the sixth transistor T6, and the light emission control line 155 and the gate electrode of the fifth transistor T5 and the sixth transistor T6 may be integrally formed.

The first gate conductive layer may include a metal such as copper (Cu), molybdenum (Mo), aluminum (Al), or titanium (Ti), or a metal alloy thereof and may be formed of a single layer or multiple layers.

After forming the first gate conductive layer including the gate electrode 1151 of the driving transistor T1, a plasma treatment or doping process is performed to impart conductivity to a portion of the first semiconductor layer that is exposed and not covered by the first gate conductive layer. That is, the first semiconductor layer covered by the first gate conductive layer is not conductive, and a portion of the first semiconductor layer not covered by the first gate conductive layer may have the same characteristics as the conductive layer. As result, a transistor including the conductive portion having a p-type transistor characteristic, for example, the driving transistor T1, the second transistor T2, the fifth transistor T5, the sixth transistor T6, and the seventh transistor T7, may be formed.

Referring to FIG. 16, a second gate insulating layer 142 may be disposed on the first gate conductive layer including the gate electrode 1151 of the driving transistor T1 and the first gate insulating layer 141. The second gate insulating layer 142 may be an inorganic insulating layer including a silicon oxide (SiOₓ), a silicon nitride (SiNₓ), or a silicon oxynitride (SiOₓN_{y}).

Referring to FIG. 6, a second gate conductive layer including the first storage electrode 1153 of the storage capacitor Cst, a lower shielding layer 3155 of the third transistor T3, and a lower shielding layer 4155 of the fourth transistor T4 may be disposed on the second gate insulating layer 142. The lower shielding layers 3155 and 4155 are disposed below the channels of the third transistor T3 and the fourth transistor T4, respectively, and may serve to shield from light or electromagnetic interference provided to the channel from the lower side. Here, the lower shielding layers 3155 and 4155 may form a part of the lower second scan line 152a and the lower initialization control line 153a, respectively.

The first storage electrode 1153 overlaps with the gate electrode 1151 of the driving transistor T1 to form the storage capacitor Cst. An opening 1152 is formed in the first storage electrode 1153 of the storage capacitor Cst. The opening 1152 of the first storage electrode 1153 of the storage capacitor Cst may overlap the gate electrode 1151 of the driving transistor T1. The first storage electrode 1153 is formed in an island shape.

The lower shielding layer 3155 of the third transistor T3 is a part of the lower second scan line 152a, and may overlap the channel 3137 and the gate electrode 3151 of the third transistor T3. The lower shielding layer 4155 of the fourth transistor T4 is a part of the lower initialization control line 153a and may overlap the channel 4137 and the gate electrode 4151 of the fourth transistor T4.

The lower second scan line 152a and lower initialization control line 153a may extend in a substantially horizontal direction (first direction). The lower second scan line 152a may be integrally formed with and connected to the lower shielding layer 3155 of the third transistor T3. The lower initialization control line 153a is connected to the lower shielding layer 4155 of the fourth transistor T4 and may be integrally formed.

The second gate conductive layer GAT2 may include a metal such as copper (Cu), molybdenum (Mo), aluminum (Al), or titanium (Ti) or a metal alloy thereof, and may be formed of a single layer or multiple layers.

Referring to FIG. 16, a first interlayer insulating layer 161 may be disposed on the second gate conductive layer GAT2 that includes the first storage electrode 1153 of the storage capacitor Cst, the lower shielding layer 3155 of the third transistor T3, and the lower shielding layer 4155 of the fourth transistor T4. The first interlayer insulating layer 161 may include an inorganic insulating layer including a silicon oxide (SiOₓ), a silicon nitride (SiNₓ), or a silicon oxynitride (SiOₓN_{y}), and depending on embodiments, the inorganic insulating material may be thickly formed.

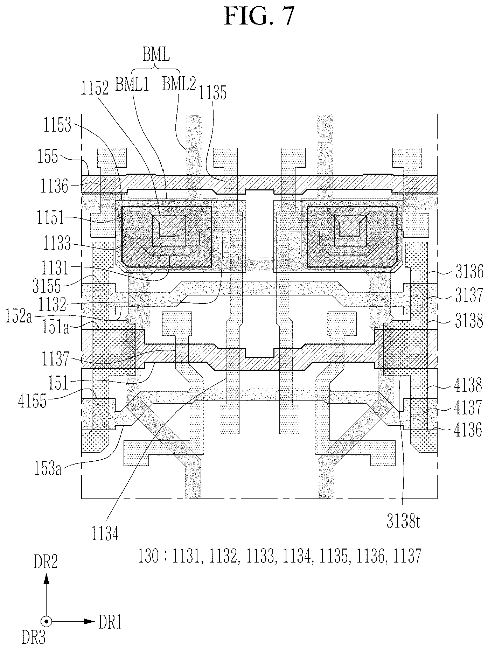

Referring to FIG. 7, an oxide semiconductor layer including the channel 3137, the first region 3136, and the second region 3138 of the third transistor T3, the channel 4137, the first region 4136, and the second region 4138 of the fourth transistor T4 may be disposed on the first interlayer insulating layer 161

In addition, the oxide semiconductor layer may include an upper boost electrode 3138t of the capacitor C_{boost}.

The channel 3137, the first region 3136, and the second region 3138 of the third transistor T3 and the channel 4137, the first region 4136, and the second region 4138 of the fourth transistor T4 are connected with each other and thus may be integrally formed. The first region 3136 and the second region 3138 of the third transistor T3 are disposed on both sides of the channel 3137 of the third transistor T3, and the first region 4136 and the second region 4138 of the fourth transistor T4 are disposed on both sides of the channel 4137 of the fourth transistor T4. The second region 3138 of the third transistor T3 is connected to the second region 4138 of the fourth transistor T4. The channel 3137 of the third transistor T3 overlaps the lower shielding layer 3155, and the channel 4137 of the fourth transistor T4 overlaps the lower shielding layer 4155.

The upper boost electrode 3138t of the capacitor C_{boost} having an extended width is disposed between the second region 3138 of the third transistor T3 and the second region 4138 of the fourth transistor T4. The upper boost electrode 3138t of the boost capacitor C_{boost} overlaps with the lower boost electrode 151a of the boost capacitor C_{boost} disposed on the first gate conductive layer in a plan view to form the boost capacitor C_{boost}.

Referring to FIG. 16, a third gate insulating layer 143 may be disposed on an oxide semiconductor layer that includes the channel 3137, the first region 3136, and the second region 3138 of the third transistor T3, the channel 4137, the first region 4136, and the second region 4138 of the fourth transistor T4, and the upper boost electrode 3138t of the boost capacitor C_{boost}.

The third gate insulating layer 143 may be disposed on the entire surface of the oxide semiconductor layer and the first interlayer insulating layer 161. Thus, the third gate insulating layer 143 may cover upper and side surfaces of the channel 3137, the first region 3136, and the second region 3138 of the third transistor T3, the channel 4137, the first region 4136, and the second region 4138 of the fourth transistor T4, and the upper boost electrode 3138t of the boost capacitor C_{boost}. However, the present embodiment is not limited thereto, and the third gate insulating layer 143 may not be disposed on the entire surface of the oxide semiconductor layer and the first interlayer insulating layer 161. For example, the third gate insulating layer 143 may overlap the channel 3137 of the third transistor T3 and may not overlap the first region 3136 and the second region 3138. In addition, the third gate insulating layer 143 may overlap the channel 4137 of the fourth transistor T4 and may not overlap the first region 4136 and the second region 4138.

The third gate insulating layer 143 may include an inorganic insulating layer that includes a silicon oxide (SiOₓ), a silicon nitride (SiNₓ), or a silicon oxynitride (SiOₓN_{y}).

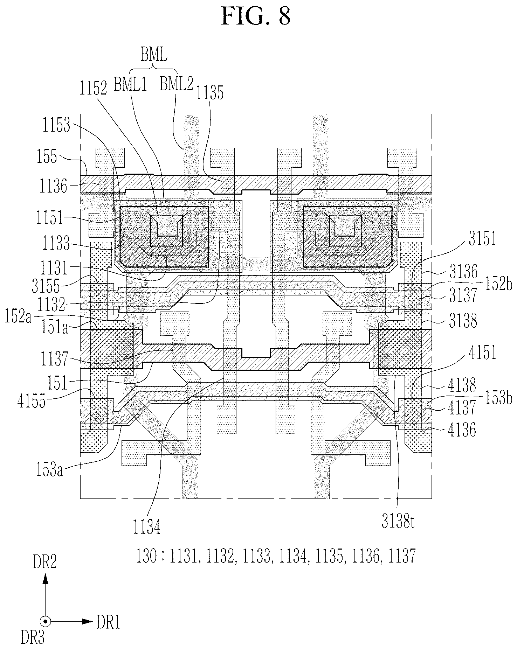

Referring to FIG. 8, a third gate conductive layer that includes the gate electrode 3151 of the third transistor T3 and the gate electrode 4151 of the fourth transistor T4 may be disposed on the third gate insulating layer 143.

The gate electrode 3151 of the third transistor T3 may overlap the channel 3137 of the third transistor T3. The gate electrode 3151 of the third transistor T3 may overlap the lower shielding layer 3155 of the third transistor T3.

The gate electrode 4151 of the fourth transistor T4 may overlap the channel 4137 of the fourth transistor T4. The gate electrode 4151 of the fourth transistor T4 may overlap the lower shielding layer 4155 of the fourth transistor T4.

The third gate conductive layer may further include an upper second scan line 152b and an upper initialization control line 153b.

The upper second scan line 152b and upper initialization control line 153b may extend in a substantially horizontal direction (first direction DR1). The upper second scan line 152b includes the gate electrode 3151 of the third transistor T3 and forms the second scan line 152 together with the lower second scan line 152a. The upper initialization control line 153b includes the gate electrode 4151 of the fourth transistor T4 and forms the initialization control line 153 together with the lower initialization control line 153a.

The third gate conductive layer GAT3 may include a metal such as copper (Cu), molybdenum (Mo), aluminum (Al), or titanium (Ti), or a metal alloy thereof, and may be formed of a single layer or multiple layers.

After forming the third gate conductive layer including the gate electrode 3151 of the third transistor T3 and the gate electrode 4151 of the fourth transistor T4, a portion of the oxide semiconductor layer covered by the third gate conductive layer is formed as a channel and a portion of the oxide semiconductor layer not covered by the third gate conductive layer may be imparted with conductivity through a plasma treatment or doping process. The channel 3137 of the third transistor T3 may be disposed under the gate electrode 3151 to overlap with the gate electrode 3151 in a plan view. The first region 3136 and the second region 3138 of the third transistor T3 may not overlap the gate electrode 3151. The channel 4137 of the fourth transistor T4 may be disposed under the gate electrode 4151 to overlap with the gate electrode 4151 in a plan view. The first region 4136 and the second region 4138 of the fourth transistor T4 may not overlap the gate electrode 4151. The upper boost electrode 3138t may not overlap the third gate conductive layer. A transistor including an oxide semiconductor layer may have characteristics of an n-type transistor.

Referring to FIG. 16, a second interlayer insulating layer 162 may be disposed on the third gate conductive layer including the gate electrode 3151 of the third transistor T3 and the gate electrode 4151 of the fourth transistor T4. The second interlayer insulating layer 162 may have a single layer or multi-layered structure. The second interlayer insulating layer 162 may include an inorganic insulating material such as a silicon oxide (SiOₓ), a silicon nitride (SiNₓ), or a silicon oxynitride (SiOₓN_{y}), and may include an organic material depending on embodiments.

Referring to FIG. 9, two types of openings OP1 and OP2 may be formed through the second interlayer insulating layer 162. Two types of openings OP1 and OP2 may be formed using different masks. In addition, a lower layer opening OPv1 (hereinafter also referred to as an opening corresponding to a valley portion) may be formed together with at least one of the two types of openings OP1 and OP2. The lower layer opening OPv1 is disposed along the periphery of the pixel circuit portion PC and corresponds to the planar structure of the valley portion (refer to VLY in FIG. 1).

Specifically, the opening OP1 may expose the first semiconductor layer 130, a first gate conductive layer, or a second gate conductive layer by forming an opening in at least one of the second interlayer insulating layer 162, the third gate insulating layer 143, the first interlayer insulating layer 161, the second gate insulating layer 142, and the first gate insulating layer 141.

The opening OP2 may expose the oxide semiconductor layer or the third gate conductive layer by forming an opening in the second interlayer insulating layer 162 and/or the third gate insulating layer 143.

One of the openings OP1 overlaps at least a portion of the gate electrode 1151 of the driving transistor T1 and may also be formed through the third gate insulating layer 143, the first interlayer insulating layer 161, and the second gate insulating layer 142. In this case, one of the openings OP1 may overlap the opening 1152 of the first storage electrode 1153 and may be disposed inside the opening 1152 of the first storage electrode 1153.

One of the openings OP2 may at least partially overlap the boost capacitor C_{boost} and may be further formed through the third gate insulating layer 143.

Another one of the openings OP1 overlaps at least a part of the second region 1133 of the driving transistor T1 and may be formed through the third gate insulating layer 143, the first interlayer insulating layer 161, the second gate insulating layer 142, and the first gate insulating layer 141.

Another one of the openings OP2 overlaps at least a part of the first region 3136 of the third transistor T3 and may be formed through the third gate insulating layer 143.

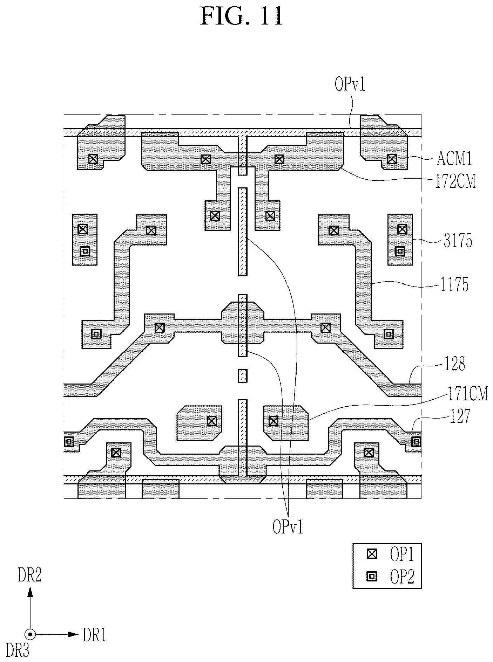

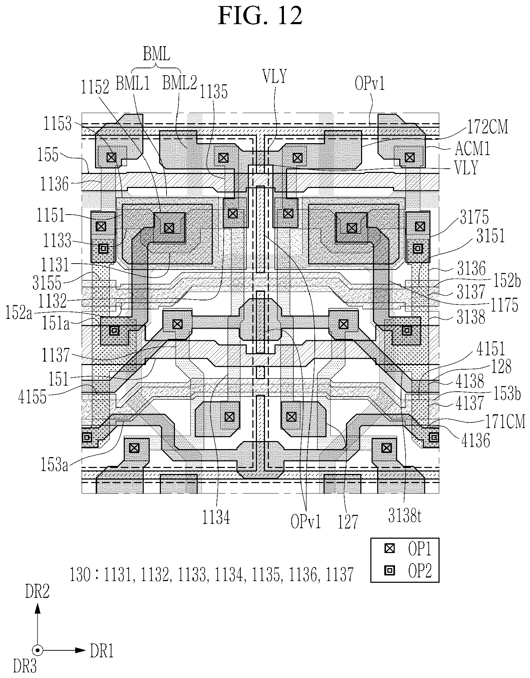

Meanwhile, a lower layer opening OPv1 corresponding to the planar structure of the valley portion (refer to VLY in FIG. 1) may be formed through at least one of the second interlayer insulating layer 162, the third gate insulating layer 143, the first interlayer insulating layer 161, the second gate insulating layer 142, and the first gate insulating layer 141. The lower layer opening OPv1 according to the embodiment may be formed through all of the second interlayer insulating layer 162, the third gate insulating layer 143, the first interlayer insulating layer 161, the second gate insulating layer 142, and the first gate insulating layer 141. In this case, a portion where the lower layer opening OPv1 is disposed may have a structure in which the second interlayer insulating layer 162, the third gate insulating layer 143, the first interlayer insulating layer 161, the second gate insulating layer 142, and the first gate insulating layer 141 are removed and be areas in which the conductive layer and/or the semiconductor layer disposed on the first gate insulating layer 141 and under the second interlayer insulating layer 162 are not disposed. Meanwhile, a metal layer BML disposed below the first gate insulating layer 141 may be formed in areas in which the lower layer opening OPv1 is disposed while crossing the lower layer opening OPv1, and the conductive layer disposed above the second interlayer insulating layer 162, for example, the first data conductive layer shown in FIG. 11 and FIG. 12 may be formed in the areas in which the lower layer opening OPv1 is disposed while crossing the lower layer opening OPv1.

Referring to FIG. 9, the lower layer opening OPv1 includes a first portion extending in the first direction DR1 and a second portion extending in the second direction DR2. The first portion of the lower layer opening OPv1 extends continuously without a disconnected portion, and the second portion is disconnected in which the valley portion openings (refer to VLYo in FIG. 1) is disposed. Here, referring to FIG. 9, in a portion where the lower layer opening OPv1 is disconnected, the second interlayer insulating layer 162, the third gate insulating layer 143, the first interlayer insulating layer 161, the second gate insulating layer 142, and the first gate insulating layer 141 are not removed but are remained continuously with areas other than the lower layer opening OPv1 is formed. Referring to FIG. 9, in the portion where the lower layer opening OPv1 is disconnected, the first scan line 151, the light emission control line 155, the lower second scan line 152a, the lower initialization control line 153a, the upper second scan line 152b, and/or the upper initialization control line 153b are disposed while crossing thereover. The lower layer opening OPv1 may have a structure that prevents the semiconductor layer and/or conductive layer from being connected, but the metal layer BML disposed below the first gate insulating layer 141 in which the lower layer opening OPv1 is formed may be formed while crossing the lower layer opening OPv1 with the second direction DR2.

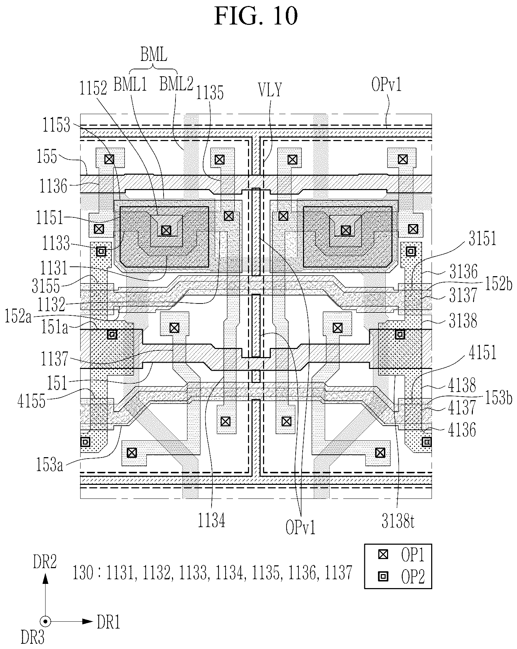

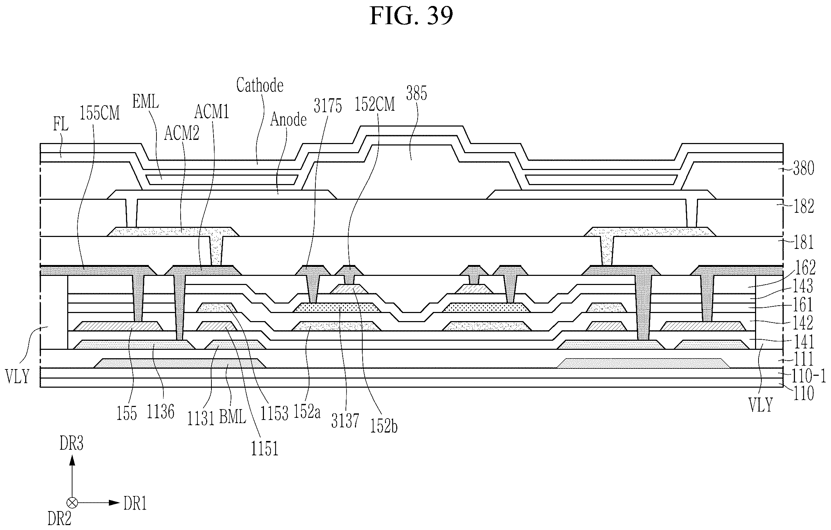

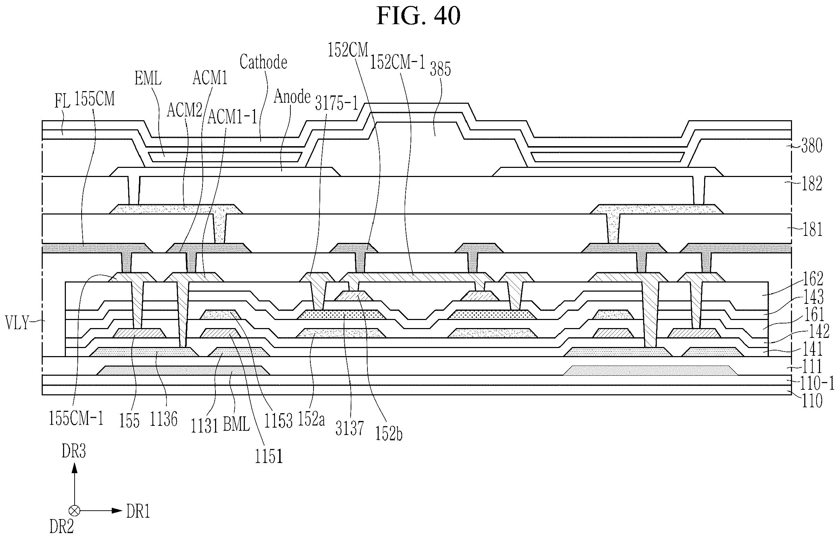

After that, referring to FIG. 10, the valley portion VLY is formed by filling the lower layer opening OPv1 with an organic material (refer to VLYo in FIG 1). The organic material forming the valley portion VLY (hereinafter, also referred to as organic material for the valley) may only fill the lower layer opening OPv1 and not be disposed on the second interlayer insulating layer 162 as shown in FIG. 39, and, depending on embodiments, as shown in FIG. 40, the organic material forming the valley portion VLY may also be disposed on the second interlayer insulating layer 162. Here, the organic material for the valley may include at least one material selected from the group consisting of polyimide, polyamide, acryl resin, benzocyclobutene, and phenol resin.

Referring to FIG. 11 and FIG. 12, a first data conductive layer including a first connecting electrode 1175 and a second connecting electrode 3175 may be disposed on the second interlayer insulating layer 162. Since the first data conductive layer cannot be easily recognized in FIG. 12, FIG. 11 shows only the first data conductive layer, the openings OP1 and OP2, and the lower layer opening OPv1 through a top plan view.

The first connecting electrode 1175 may overlap the gate electrode 1151 of the driving transistor T1. The first connecting electrode 1175 may be connected to the gate electrode 1151 of the driving transistor T1 through the opening 1152 of the opening OP1 and the first storage electrode 1153. The first connecting electrode 1175 may overlap the boost capacitor C_{boost}. The first connecting electrode 1175 may be connected with the upper boost electrode 3138t of the boost capacitor C_{boost} through the opening OP2. Thus, the gate electrode 1151 of the driving transistor T1 and the upper boost electrode 3138t of the boost capacitor C_{boost} may be connected by the first connecting electrode 1175. In this case, the gate electrode 1151 of the driving transistor T1 may also be connected with the second region 3138 of the third transistor T3 and the second region 4138 of the fourth transistor T4 by the first connecting electrode 1175.

The second connecting electrode 3175 may overlap the second region 1133 of the driving transistor T1. The second connecting electrode 3175 may be connected to the second region 1133 of the driving transistor T1 through the opening OP1. The second connecting electrode 3175 may overlap the first region 3136 of the third transistor T3. The second connecting electrode 3175 may be connected to the first region 3136 of the third transistor T3 through the opening OP2. Accordingly, the second region 1133 of the driving transistor T1 and the first region 3136 of the third transistor T3 may be connected by the second connecting electrode 3175.

The first data conductive layer may further include a first initialization voltage line 127 and a second initialization voltage line 128. The first initialization voltage line 127 and the second initialization voltage line 128 extend along the first direction DR1.

The first initialization voltage line 127 is connected to a portion 4136 of the second semiconductor layer (i.e., oxide semiconductor layer) through the opening OP2, and transmits the first initialization voltage Vinit flowing through the first initialization voltage line 127 to the fourth transistor T4 of the oxide semiconductor layer.

The second initialization voltage line 128 is electrically connected to a portion 1137 of the first semiconductor layer 130 through the opening OP1, and the second initialization voltage AVinit is transmitted to the seventh transistor T7.

The first data conductive layer may additionally include connecting electrodes 171CM and 172CM and an anode connecting electrode ACM1.

The connecting electrode 171CM is electrically connected to the portion 1137 of the first semiconductor layer 130, that is, the second transistor T2, through the opening OP1.

The connecting electrode 172CM is electrically connected to the portion 1135 of the first semiconductor layer 130 through the opening OP1, and also electrically connected to the first storage electrode 1153 of the storage capacitor Cst through another opening OP1. The connecting electrode 172CM is connected to the driving voltage line 172 in a subsequent process and the driving voltage ELVDD is transmitted such that the driving voltage ELVDD is transmitted to the fifth transistor T5 and the storage capacitor Cst.

The anode connecting electrode ACM1 is electrically connected to a portion 1136 of the first semiconductor layer 130, that is, the sixth transistor T6, through the opening OP1.

The first data conductive layer may include a metal such as aluminum (Al), copper (Cu), molybdenum (Mo), or titanium (Ti), or a metal alloy thereof, and may be formed of a single layer or multiple layers.

Referring to FIG. 16, a first organic layer 181 may be disposed on the first data conductive layer including the first connecting electrode 1175 and the second connecting electrode 3175. The first organic layer 181 may be an organic insulator including an organic material, and the organic material may include at least one material selected from the group consisting of polyimide, polyamide, acryl resin, benzocyclobutene, and phenol resin.

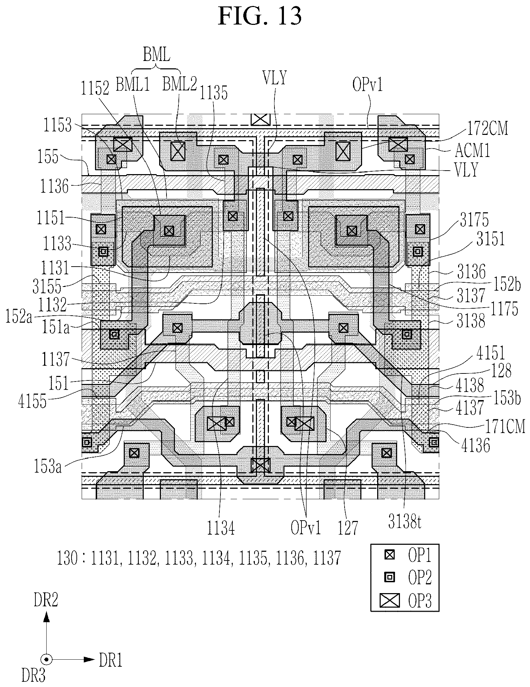

Referring to FIG. 13, a lower organic layer opening OP3 is disposed in the first organic layer 181.

The lower organic layer opening OP3 is formed in areas corresponding to the connecting electrodes 171CM and 172CM and the anode connecting electrode ACM1, which are disposed on the first data conductive layer, to expose them respectively. In addition, the lower organic layer opening OP3 may overlap the first initialization voltage line 127 or the second initialization voltage line 128, and in the embodiment of FIG. 13, it overlaps with the first initialization voltage line 127.

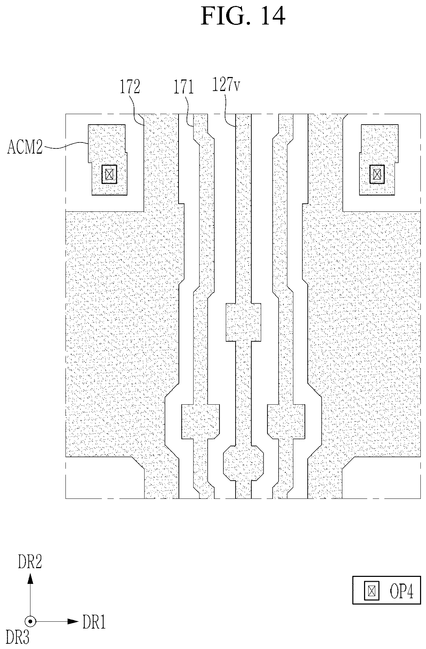

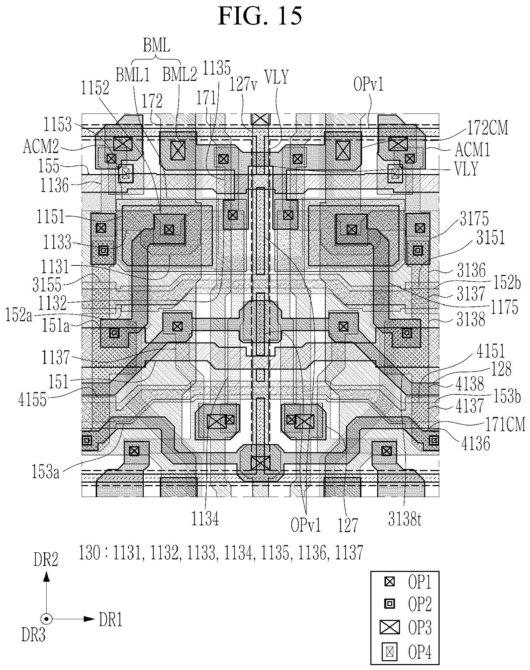

Referring to FIG. 14 and FIG. 15, a second data conductive layer including the data line 171, the driving voltage line 172, a 1-1 initialization voltage line 127v, and an anode connecting electrode ACM2 may be disposed on the first organic layer 181. Since the second data conductive layer cannot be easily recognized in 14, FIG. 15 shows only the second data conductive layer and the opening OP through a top plan view, and FIG. 15 is a top plan view that shows the second data conductive layer and all layers around it.

The data line 171, the driving voltage line 172, and the 1-1 initialization voltage line 127v may extend in the second direction DR2. The data line 171 is connected to the connecting electrode 171CM of the first data conductive layer through the lower organic layer opening OP3, and is connected to the second transistor T2 therethrough. The driving voltage line 172 is connected to the connecting electrode 172CM through the lower organic layer opening OP3, and electrically connected to the fifth transistor T5 and the first storage electrode 1153 through the connecting electrode 172CM. The 1-1 initialization voltage line 127v is electrically connected to the first initialization voltage line 127 through the opening OP3. Depending on the position of the display area, the 2-1 initialization voltage line that delivers the second initialization voltage AVinit may be disposed instead of the 1-1 initialization voltage line 127v that transmits the first initialization voltage Vinit. In this case, the lower organic layer opening OP3 may overlap the second initialization voltage line 128 instead of the first initialization voltage line 127.

The anode connecting electrode ACM2 is electrically connected to the anode connecting electrode ACM1 of the first data conductive layer through the opening OP3 and electrically connected to the sixth transistor T6.

Referring to FIG. 14 and FIG. 15, the driving voltage line 172 further includes an expansion portion, which is a widely expanded portion, and may serve to planarize the anode disposed thereabove.

The second data conductive layer may include a metal such as aluminum (Al), copper (Cu), molybdenum (Mo), or titanium (Ti), or a metal alloy thereof, and may be formed of a single layer or multiple layers.

Referring to FIG. 16, a second organic layer 182 is disposed on the second data conductive layer. The second organic layer 182 may be an organic insulator and may include at least one material selected from the group consisting of polyimide, polyamide, acryl resin, benzocyclobutene, and phenol resin. Depending on embodiments, an additional organic layer (third organic layer) may be formed on the second organic layer 182.

Referring back to FIG. 14 and FIG. 15, an opening OP4 for connecting the anode is formed in the second organic layer 182, through which the anode and the anode connecting electrode ACM2 are electrically connected.

Hereinafter, a cross-sectional structure of the light emitting display device will be described through FIG. 16, and a stacking structure of the light emitting diode LED including the anode will also be described.

FIG. 16 is a cross-sectional view of the light emitting display device according to the embodiment.

In the light emitting display device according to the embodiment, the pixel circuit portion forming the pixel may be disposed below the second organic layer 182, and the light emitting diode LED forming the pixel is disposed above the second organic layer 182 and disposed below an encapsulation layer (not shown).

Referring to FIG. 16, the metal layer BML is disposed on the substrate 110.

The substrate 110 may include a material that has rigid characteristics such as glass and does not bend, or may include a flexible material that can bend such as plastic or polyimide. In the case of the flexible substrates, as shown in FIG. 16, a double-layer structure of polyimide and a barrier layer 110-1 formed of an inorganic insulating material thereon may have a double structure.

The metal layer BML may be formed at a position overlapping with the channel of the driving transistor T1 in a plan view among the following first semiconductor layers, and is also referred to as a lower shielding layer. The metal layer BML may include a metal such as copper (Cu), molybdenum (Mo), aluminum (Al), or titanium (Ti), or a metal alloy thereof.

A buffer layer 111 covering the substrate 110 and the metal layer BML is disposed on the substrate 110 and the metal layer BML. The buffer layer 111 serves to block the penetration of impurities into the first semiconductor layer, and may be an inorganic insulating layer including a silicon oxide (SiOₓ), a silicon nitride (SiNₓ), or a silicon oxynitride (SiOₓN_{y}).

A first semiconductor layer formed of silicon semiconductor (e.g., polycrystalline semiconductor (P-Si)) is disposed on the buffer layer 111. The first semiconductor layer includes portions that form the channel 1131 of the driving transistor T1 and other transistors, and FIG. 16 shows a portion 1136 included in the sixth transistor T6. Here, the transistor (hereinafter, also referred to as a polycrystalline transistor) including the first semiconductor layer may include not only the driving transistor T1 but also the second transistor T2, the fifth transistor T5, the sixth transistor T6, and the seventh transistor T7. In addition, both sides of the channel of the first semiconductor layer have a region having a conductivity by plasma treatment or doping, and may serve as the first electrode and second electrode of the transistor.

The first gate insulating layer 141 may be disposed on the first semiconductor layer. The first gate insulating layer 141 may include an inorganic insulating layer that includes a silicon oxide (SiOₓ), a silicon nitride (SiNₓ), or a silicon oxynitride (SiOₓN_{y}).

The first gate conductive layer including a gate electrode of a polycrystalline transistor may be disposed on the first gate insulating layer 141. In the first gate conductive layer, a scan line or a light emission control line 155 may be formed in addition to the gate electrode 1151 of the polycrystalline transistor. The first gate conductive layer may include a metal such as copper (Cu), molybdenum (Mo), aluminum (Al), or titanium (Ti) or a metal alloy thereof, and may be formed of a single layer or multiple layers.

After forming the first gate conductive layer, a plasma treatment or a doping process may be performed to make the exposed region of the first semiconductor layer conductive. That is, the first semiconductor layer covered by the first gate conductive layer is not conductive and portions of the first semiconductor layer not covered by the first gate conductive layer may have the conductivity.

A second gate insulating layer 142 may be disposed on the first gate conductive layer and the first gate insulating layer 141. The second gate insulating layer 142 may be an inorganic insulating layer including a silicon oxide (SiOₓ), a silicon nitride (SiNₓ), or a silicon oxynitride (SiOₓN_{y}).

A second gate conductive layer GAT2 including one electrode 1153 of the storage capacitor Cst and scan lines such as a lower second scan line 152 and the lower shielding layer of the oxide transistor may be disposed on the second gate insulating layer 142. The lower shielding layer of the oxide transistor may be disposed below the channel of the oxide transistor to shield from light or electromagnetic interference provided to the channel from the lower side. Meanwhile, the one electrode 1153 of the storage capacitor Cst overlaps with the gate electrode 1151 of the driving transistor T1 to form the storage capacitor Cst. Depending on embodiments, the second gate conductive layer may further include a scan line, a control line, or a voltage line. The second gate conductive layer may include a metal such as copper (Cu), molybdenum (Mo), aluminum (Al), or titanium (Ti), or a metal alloy thereof, and may be formed of a single layer or multiple layers.

A first interlayer insulating layer 161 may be disposed on the second gate conductive layer. The first interlayer insulating layer 161 may include an inorganic insulating layer including a silicon oxide (SiOₓ), a silicon nitride (SiNₓ), or a silicon oxynitride (SiOₓN_{y}), and depending on embodiments, an inorganic insulating material may be formed thickly.

An oxide semiconductor layer (also referred to as a second semiconductor layer) including a channel 3137, a first region, and a second region of an oxide transistor may be disposed on the first interlayer insulating layer 161.

The third gate insulating layer 143 may be disposed on the oxide semiconductor layer. The third gate insulating layer 143 may be disposed on the entire surface of the oxide semiconductor layer and the first interlayer insulating layer 161. The third gate insulating layer 143 may include an inorganic insulating layer including a silicon oxide (SiOₓ), a silicon nitride (SiNₓ), or a silicon oxynitride (SiOₓN_{y}).

A third gate conductive layer including a gate electrode of an oxide transistor may be disposed on the third gate insulating layer 143. The gate electrode of the oxide transistor may overlap the channel, and the upper second scan line 152b has a structure including the gate electrode of the oxide transistor and overlapping the channel of the oxide transistor. The third gate conductive layer GAT3 may further include a scan line or a control line. The third gate conductive layer GAT3 may include a metal such as copper (Cu), molybdenum (Mo), aluminum (Al), or titanium (Ti) or a metal alloy thereof, and may be formed of a single layer or multiple layers.

The second interlayer insulating layer 162 may be disposed on the third gate conductive layer GAT3. The second interlayer insulating layer 162 may have a single layer or multi-layered structure. The second interlayer insulating layer 162 may include an inorganic insulating material such as a silicon oxide (SiOₓ), a silicon nitride (SiNₓ), or a silicon oxynitride (SiOₓN_{y}), and depending on embodiments, it may include an organic material.

On the second interlayer insulating layer 162, a first data conductive layer including the connecting electrodes 3175 and ACM1 that can be connected to the first region and the second region of each of the polycrystalline transistor and the oxide transistor may be disposed. The first data conductive layer may include a metal such as aluminum (Al), copper (Cu), molybdenum (Mo), or titanium (Ti) or a metal alloy thereof, and may be formed of a single layer or multiple layers.

The first organic layer 181 may be disposed on the first data conductive layer. The first organic layer 181 may be an organic insulator including an organic material, and the organic material may include at least one material selected from the group consisting of polyimide, polyamide, acryl resin, benzocyclobutene, and phenol resin.

A second data conductive layer including an anode connecting electrode ACM2 may be disposed on the first organic layer 181. The second data conductive layer may include a data line or a driving voltage line. The second data conductive layer may include a metal such as aluminum (Al), copper (Cu), molybdenum (Mo), or titanium (Ti), or a metal alloy thereof, and may be formed of a single layer or multiple layers.

The second organic layer 182 is disposed on the second data conductive layer. The anode connecting electrode ACM2 is electrically connected to an anode Anode through the anode connection opening. The second organic layer 182 may be an organic insulator and may include at least one material selected from the group consisting of polyimide, polyamide, acryl resin, benzocyclobutene, and phenol resin. Depending on embodiments, a third organic layer may be further formed on the second organic layer 182.

The anode Anode is formed on the second organic layer 182.

A pixel defining layer 380 covering at least a part of the anode Anode while having an opening exposing the anode Anode may be disposed on the anode Anode. The pixel defining layer 380 may be formed of a black organic material to prevent light applied from the outside from being reflected back to the outside, and may be formed of a transparent organic material depending on embodiments. Therefore, according to the embodiment, the pixel defining layer 380 may include a negative type black color organic material or may include a black color pigment.

A spacer 385 is disposed on the pixel defining film 380. Unlike the pixel define layer 380, the spacer 385 may be formed of a transparent organic insulating material. Depending on embodiments, the spacer 385 may be formed of a transparent organic material of a positive type.

A functional layer FL and a cathode Cathode are sequentially formed on the anode Anode, the spacer 385, and the pixel defining film 380, and the functional layer FL and the cathode Cathode, may be disposed in the entire region. The emission layer EML is disposed between the functional layers FL, and the emission layer EML may be disposed only within the opening of the pixel defining film 380. Hereinafter, the combination of the functional layer FL and the emission layer EML may be referred to as an intermediate layer. The functional layer FL may include at least one layer among auxiliary layers such as an electron injection layer, an electron transport layer, a hole transport layer, and a hole injection layer, and the hole injection layer and hole transport layer are disposed below the emission layer EML and the electron transport layer and electron injection layer may be disposed on the emission layer EML.

An encapsulation layer (not shown) may be disposed on the cathode Cathode. The encapsulation layer includes at least one inorganic layer and at least one organic layer, and may have a three-layer structure including a first inorganic encapsulation layer, an organic encapsulation layer, and a second inorganic encapsulation layer sequentially disposed on the cathode Cathode depending on embodiments. The encapsulation layer may protect the emission layer EML from moisture or oxygen that may inflow from the outside. Depending on embodiments, the encapsulation layer may include a structure in which an inorganic layer and an organic layer are sequentially stacked. Depending on embodiments, a separate encapsulation substrate may be formed.

Depending on embodiments, a sensing electrode for touch sensing may be further included on the encapsulation layer, and a light blocking layer, a color filter, or a color conversion layer may be further formed. In addition, depending on embodiments, a polarizer may be additionally formed or the polarizer may be omitted.

In the cross-sectional view of FIG. 16, a cross-section structure of valley portion opening VLYo is shown instead of the valley portion VLY. In the embodiment of FIG. 16, since the valley portion opening VLYo has a structure in which a valley portion VLY having an organic material is not formed, each insulating layer (second interlayer insulating layer 162, third gate insulating layer 143, first interlayer insulating layer 161, second gate insulating layer 142, and first gate insulating layer 141) is formed continuously, and the light emission control line 155 is connected through the valley portion opening VLYo. In this case, as shown in FIG. 39, the valley portion VLY may be formed over all the second interlayer insulating layer 162, the third gate insulating layer 143, the first interlayer insulating layer 161, the second gate insulating layer 142, and the first gate insulating layer 141. That is, the valley portion VLY is formed by filling the lower layer opening OPv1 with an organic material. The organic material forming the valley portion VLY (hereinafter, also referred to as organic material for the valley) may only fill the lower layer opening OPv1 and not be disposed on the second interlayer insulating layer 162 as shown in FIG. 39, and depending on embodiments, as shown in FIG. 40, the organic material forming the valley portion VLY may also be disposed on the second interlayer insulating layer 162.

Hereinabove, the structure of light emitting display device and the pixel according to the embodiment has been described in detail.

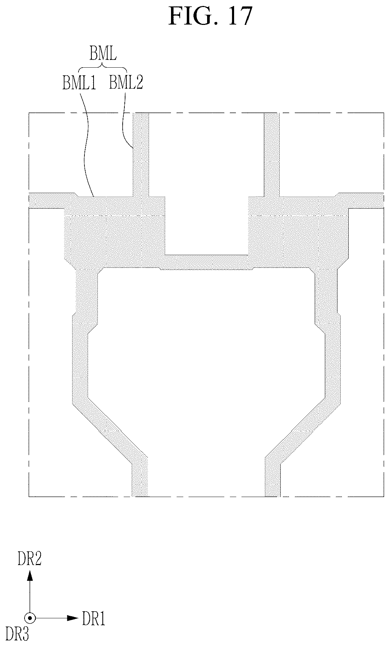

Hereinafter, a structure of a light emitting display device according to a comparative example of FIG. 17 to FIG. 25 will be compared with FIG. 3 to FIG. 16.

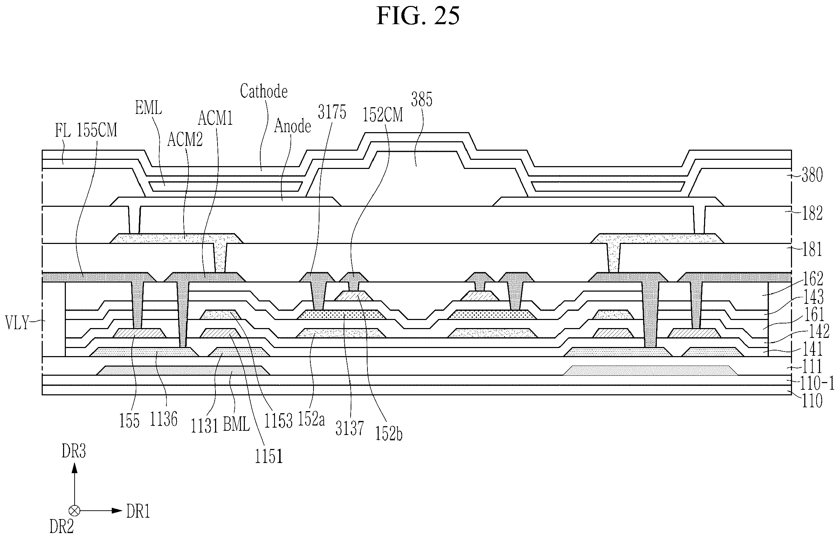

FIG. 17 to FIG. 24 show a structure of each layer according to a manufacturing sequence of a lower panel layer of a light emitting display device according to a comparative example in detail, and FIG. 25 is a cross-sectional view of the light emitting display device according to the comparative example.

In the comparative example, a portion where the valley portion VLY is disposed has a structure in which some conductive layers are disconnected, and this will be described hereinafter in detail.

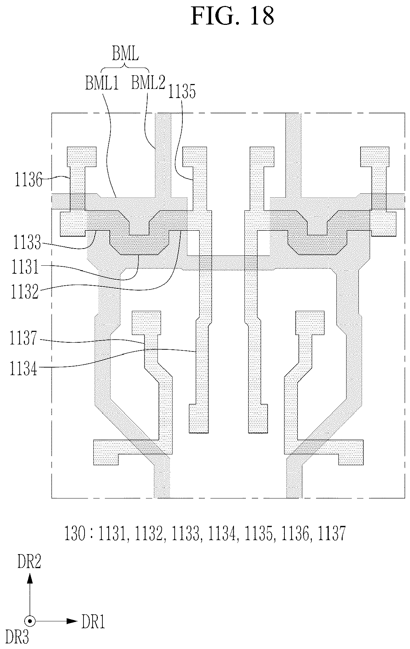

FIG. 17 and FIG. 18 are the same as FIG. 3 and FIG. 4, and FIG. 17 illustrates a metal layer BML and FIG. 18 illustrates a first semiconductor layer 130.

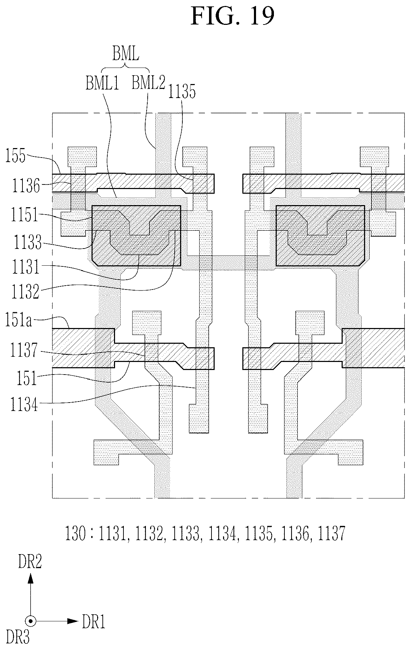

As in FIG. 5, FIG. 19 illustrates a first gate conductive layer, but a planar structure is different from that shown in FIG. 5. That is, a gate electrode 1151 of a driving transistor T1 included in the first gate conductive layer of FIG. 19 is the same as that of FIG. 5, but not as in FIG. 5, a first scan line 151 and a light emission control line 155 of FIG. 19 have a structure of being disconnected in a portion where a valley portion VLY is disposed.

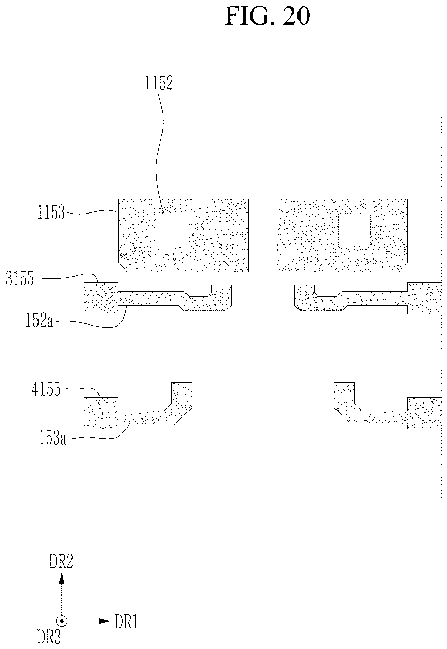

FIG. 19 additionally shows the first gate conductive layer in addition to the structure of FIG. 17 and FIG. 18, but FIG. 20 shows only a second gate conductive layer such that the difference from FIG. 6 can be more easily distinguished.

Referring to FIG. 20, the second gate conductive layer of FIG. 20 is different from the structure of FIG. 6. That is, the first storage electrode 1153 of the storage capacitor Cst included in the second gate conductive layer of FIG. 20 has the same island shape as shown in FIG. 6, but a lower second scan line 152a and a lower initialization control line 153a are different from those described in FIG. 6 and have disconnected portions where a valley portion VLY is disposed.

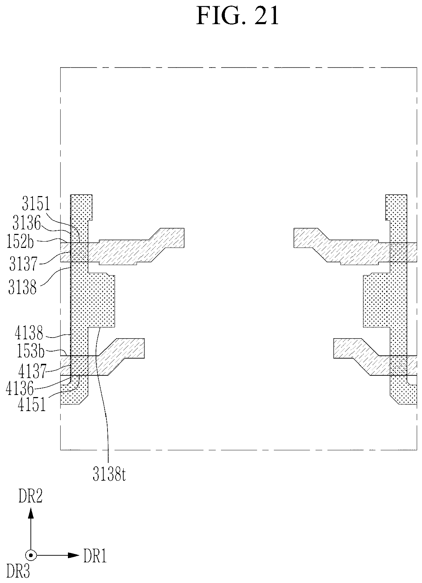

FIG. 21 illustrates an oxide semiconductor layer and a third gate conductive layer corresponding to FIG. 7 and FIG. 8, and except for the above-described conductive layer and semiconductor layer, only the oxide semiconductor layer and the third gate conductive layer are shown.

The oxide semiconductor layer of FIG. 21 has the same structure as shown in FIG. 7, but the third gate conductive layer of FIG. 21 is different from the third gate conductive layer of FIG. 8 in structure. That is, an upper second scan line 152b and an upper initialization control line 153b of FIG. 21 are different from those described in FIG. 8 and included in the third gate conductive layer of FIG. 21 have a structure of being disconnected in a portion where a valley portion VLY is disposed.

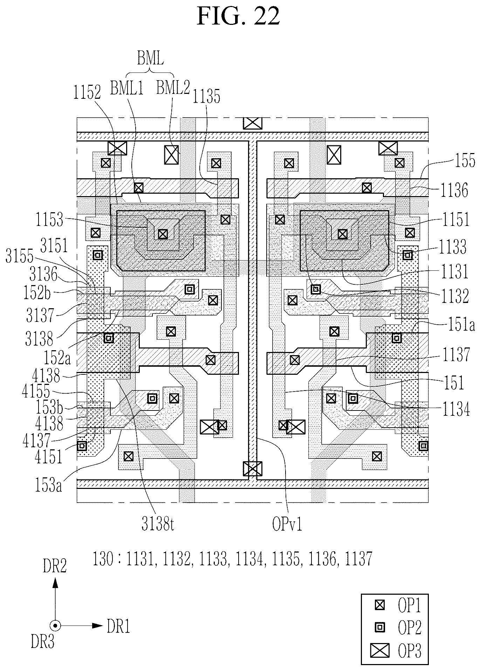

FIG. 22 illustrates the metal layer BML, the first semiconductor layer 130, the first gate conductive layer, the second gate conductive layer, the oxide semiconductor layer, and the third gate conductive layer shown in FIG. 17 to FIG. 21, and further illustrates openings OP1 and OP2 and a lower layer opening OPv1.

In the comparative example of FIG. 22, not as in FIG. 9, the lower layer opening OPv1 does not have disconnected portions in the second portion extending in the second direction DR2. That is, in the lower layer opening OPv1, a first portion extending in the first direction DR1 and a second portion extended in the second direction DR2 both are continuously extended. The openings OP1 and OP2 of FIG. 22 include all the openings shown in FIG. 9, and may further include more additional openings OP1 and OP2.

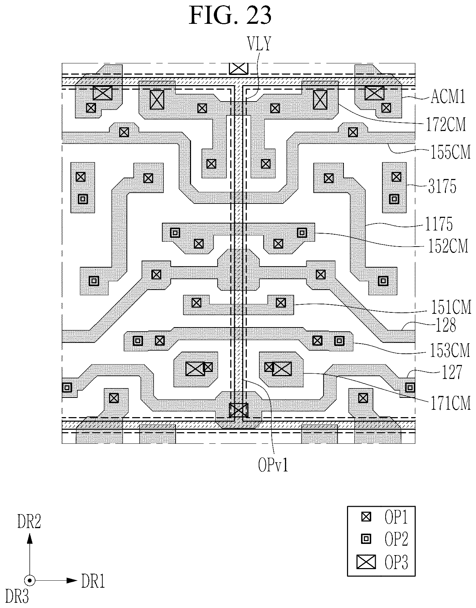

Similar to FIG. 11, in the comparative example of FIG. 23, the first data conductive layer, the openings OP1 and OP2, and the lower layer opening OPv1 are mainly illustrated, and additionally, an opening OP3 and a valley portion VLY are also illustrated.

Referring to FIG. 23, a valley portion VLY is formed by filling the lower layer opening OPv1 with an organic material and the lower layer opening OPv1 is not disconnected such that a valley portion opening (refer to VLYo in FIG. 1) is not formed. As shown in FIG. 25, the organic material (hereinafter, also referred to as an organic material for valley) forming the valley portion VLY only fills the lower layer opening OPv1 and may not be disposed on the second interlayer insulating layer 162, and depending on embodiments, as shown in FIG. 40, the organic material forming the valley portion VLY may also be disposed on the second interlayer insulating layer 162.

Compared to the embodiment of FIG. 11, in the comparative example of FIG. 23, the first data conductive layer formed on the valley portion VLY additionally includes connecting electrodes 151CM, 152CM, 153CM, and 155CM, and the additional openings OP1 and OP2 may be used to connect the additional connecting electrodes 151CM, 152CM, 153CM, and 155CM. In the comparative example of FIG. 23, the additional connecting electrodes 151CM, 152CM, 153CM, and 155CM are provided for connection of a conductive layer that has a disconnected structure in a portion where the valley portion VLY is disposed. This will now be described in detail.

In the comparative example of FIG. 23, the connecting electrode 151CM connects the first scan line 151 of FIG. 19 disposed adjacent to each other along the first direction DR1 through the opening OP1 such that the first scan lines 151 disposed along the first direction DR1 are electrically connected to one another along the first direction DR1 to across the second portions of the valley portions VLY.

In the comparative example of FIG. 23, the connecting electrode 152CM is connected to the lower second scan line 152a of FIG. 20 through the opening OP1, and is connected to the upper second scan line 152b of FIG. 21 through the opening OP2. As a result, the lower second scan lines 152a and the upper second scan lines 152b disposed adjacent each other along the first direction DR1 are electrically connected each other even in the valley portion VLY.

In the comparative example of FIG. 23, a connecting electrode 153CM is connected to the lower initialization control line 153a of FIG. 20 through the opening OP1, and is connected with the upper initialization control line 153b of FIG. 21 through the opening OP2. As a result, the lower initialization control lines 153a and the upper initialization control lines 153b disposed adjacent each other along the first direction DR1 are electrically connected each other even in the valley portion VLY.

In the comparative example of FIG. 23, the connecting electrode 155CM connects the light emission control lines 155 of FIG. 19 disposed adjacent each other through the opening OP1, and thus the light emission control line 155 is electrically connected each other even in the valley portion VLY.

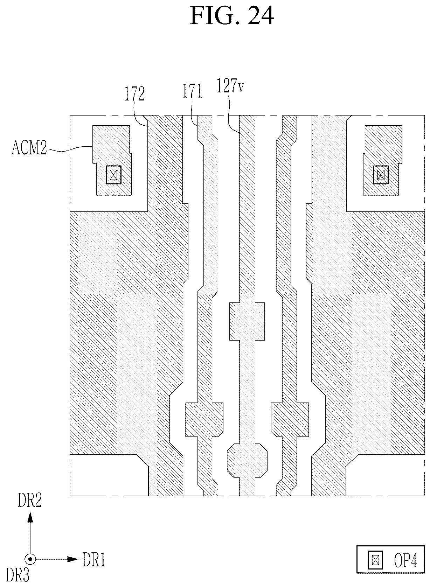

FIG. 24 corresponds to FIG. 14, and has the same structure as shown in FIG. 14.

As described, in the comparative example, some conductive layers (i.e., the first scan line 151, the lower second scan line 152a, the upper second scan line 152b, the lower initialization control line 153a, the upper initialization control line 153b, and the light emission control line 155) are disconnected in areas corresponding to the second portion of the valley portion VLY, extend in the second direction DR2 such that the additional openings OP1 and OP2 and the additional connecting electrodes 151CM, 152CM, 153CM, and 155CM are further included in the first data conductive layer to electrically connected the disconnected portions.

Compared to the embodiment of FIG. 15, in the comparative example of FIG. 25, the valley portion VLY is formed to completely surround pixel circuit portions disposed adjacent to each other along the first direction DR1, and the valley portion VLY has a structure in which an organic material is filled in the lower layer opening OPv1 formed in the second interlayer insulating layer 162, the third gate insulating layer 143, the first interlayer insulating layer 161, the second gate insulating layer 142, and the first gate insulating layer 141. In FIG. 25, the valley portion VLY may not be disposed on the second interlayer insulating layer 162. The connecting electrode 155CM may extend along the first direction DR1 on the second interlayer insulating layer 162 to cross the valley portion VLY in order to electrically connect the wiring through the valley portion VLY.

In the case of connecting the wiring through the valley portion VLY on the second interlayer insulating layer 162, as shown in FIG. 23, the first data conductive layer inevitably has a more complex structure. Therefore, there is a limit to reducing the area occupied by the pixel circuit portion PC among one pixel. As a result, there is a problem in forming a high-resolution light emitting display device.

On the contrary, in the embodiment of FIG. 11, it can be confirmed that there is a spatial margin in the first data conductive layer, and thus a higher resolution pixel circuit portion PC can be formed and a high-resolution light emitting display device can be formed. In addition, since the valley portion VLY surrounds the pixel circuit portion PC except for some valley portion opening VLYo, it is possible to manufacture a light emitting display device having high resolution and high impact resistance due to high impact resistance.

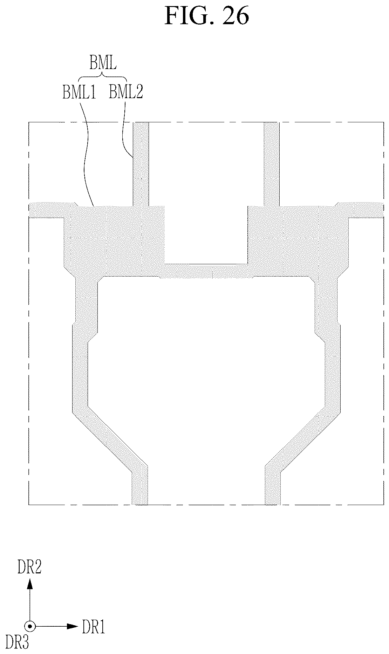

Depending on embodiments, an embodiment other than the embodiments of FIG. 3 to FIG. 16 can also form a light emitting display device with high impact resistance and high resolution, and for one of these embodiments will be described with reference to FIG. 26 to FIG. 38.

FIG. 26 to FIG. 38 show a structure of each layer according to a manufacturing sequence of a lower panel layer of a light emitting display device according to another embodiment in detail.

Compared to FIG. 3 to FIG. 16, in an embodiment of FIG. 26 to FIG. 38, some signal lines are directly connected through a valley portion opening VLYo, and some other signal lines are connected each other on an upper portion of the valley portion VLY using a first data conductive layer.

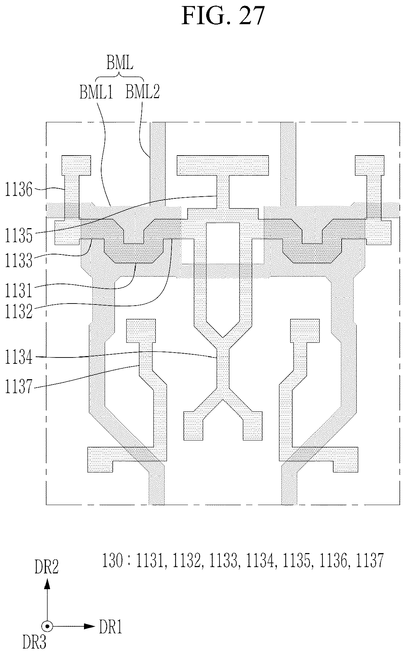

A metal layer BML of FIG. 26 has a structure identical to FIG. 3, and, unlike the first semiconductor layer shown in FIG. 4, a first semiconductor layer 130 of FIG. 27 has a structure in which two portions 1134 and 1135 are formed in common with an adjacent first semiconductor layer 130. In the embodiment of FIG. 26, the two portions 1134 and 1135 of the first semiconductor layer 130 may overlap the valley portion VLY.

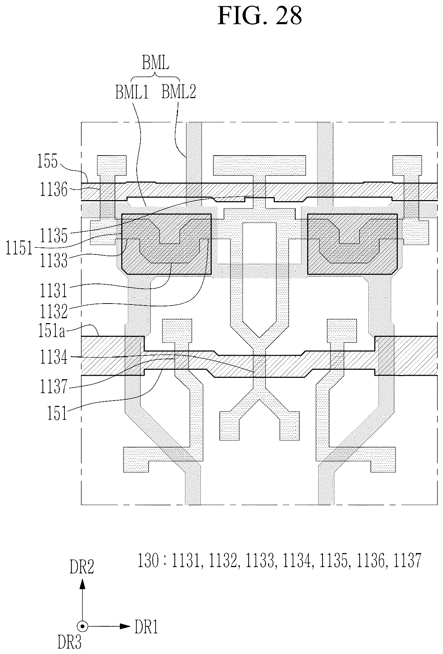

A first gate conductive layer of FIG. 28 is the same as that of FIG. 5, and has a structure in which a first scan line 151 and a light emission control line 155 continuously extend in a first direction DR1. Therefore, the first scan line 151 and the light emission control line 155 have a structure integrally formed across the valley portion opening VLYo of the valley portion VLY.

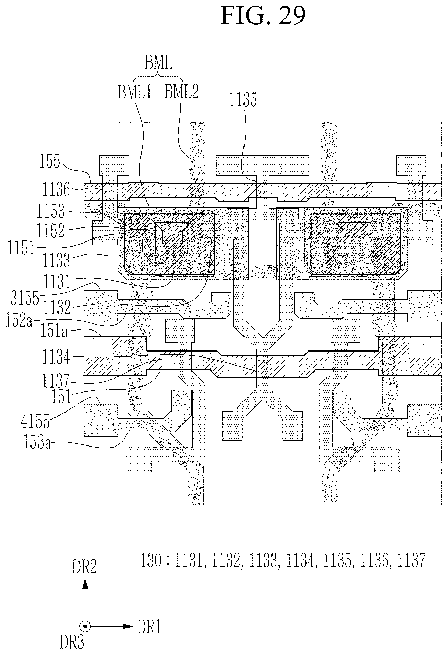

In a second gate conductive layer of FIG. 29, a first storage electrode 1153 of a storage capacitor Cst has the same island structure as that of FIG. 6, but a lower second scan line 152a and a lower initialization control line 153a of FIG. 29 have a structure including disconnected portion in areas overlapping the valley portion VLY.

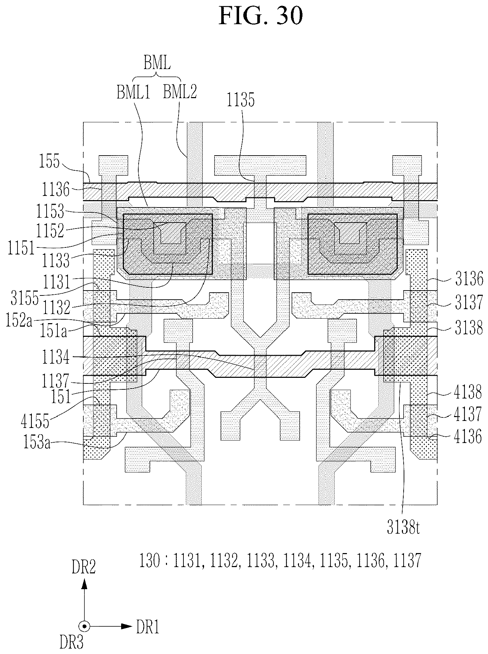

An oxide semiconductor layer of FIG. 30 has the same shape as that of FIG. 7.

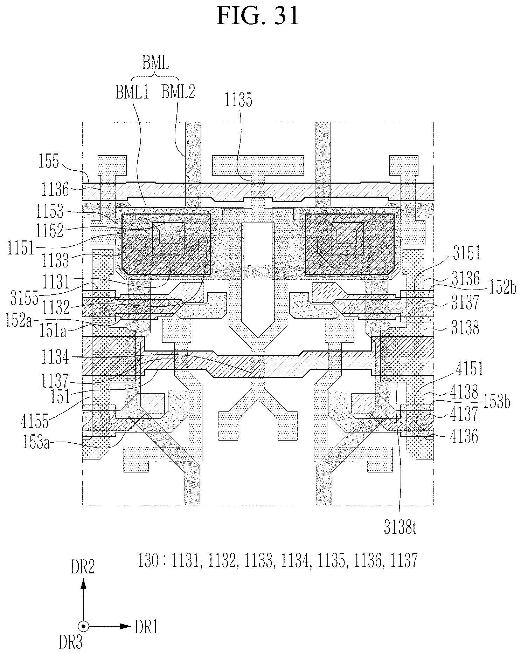

A third gate conductive layer of FIG. 31 includes an upper second scan line 152b and an upper initialization control line 153b, but the upper second scan line 152b and upper initialization control line 153b have a structure including disconnected portion in areas overlapping the valley portion VLY

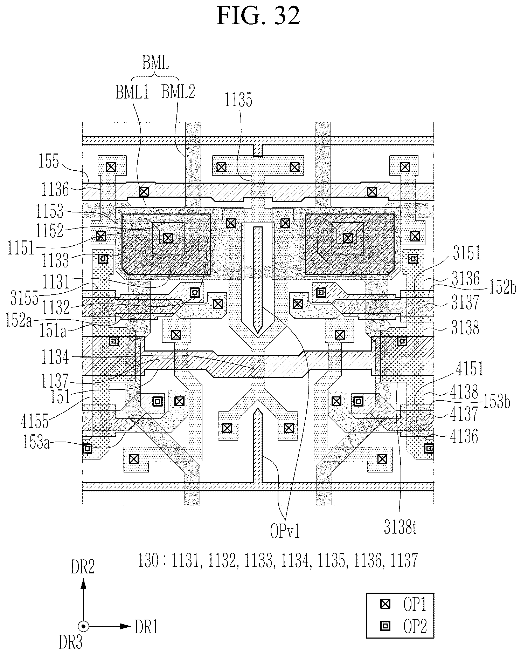

FIG. 32 illustrates openings OP1 and OP2 and a lower layer opening OPv1, and the openings OP1 and OP2 of FIG. 32 include all the openings shown in FIG. 9 and may further include many more additional openings OP1 and OP2.

FIG. 32, the lower layer opening OPv1 of FIG. 32 is different from that of FIG. 9 in structure. That is, the lower layer opening OPv1 of FIG. 32 has an island shape since a second portion extended in the second direction DR2 has a portion that is disconnected.

Here, the lower layer opening OPv1 may be formed in at least one of a second interlayer insulating layer 162, a third gate insulating layer 143, a first interlayer insulating layer 161, a second gate insulating layer 142, and a first gate insulating layer 141. The lower layer opening OPv1 according to the embodiment may be formed through all of the second interlayer insulating layer 162, the third gate insulating layer 143, the first interlayer insulating layer 161, the second gate insulating layer 142, and the first gate insulating layer 141. In this case, a portion where the lower layer opening OPv1 is positioned may have a structure in which the second interlayer insulating layer 162, the third gate insulating layer 143, first interlayer insulating layer 161, second gate insulating layer 142, and the first gate insulating layer 141 are removed, and a conductive layer and/or semiconductor layer which are/is disposed on the first gate insulating layer 141 and below the second interlayer insulating layer 162 do/does not cross the lower layer opening OPv1. On the other hand, the metal layer BML positioned below the first gate insulating layer 141 may be formed to cross the lower layer opening OPv1, and the first data conductive layer and the second data conductive layer positioned above the second interlayer insulating layer 162 may be formed to cross the lower layer opening OPv1.

Referring to FIG. 32, the lower layer opening OPv1 has a first portion extending in the first direction DR1 and a second portion extending in the second direction DR2. The first portion of the lower layer opening OPv1 extends continuously without being disconnected, and the second portion has a disconnected structure. The disconnected portion may correspond to a valley portion opening VLYo. Here, the second interlayer insulating layer 162, the third gate insulating layer 143, the first interlayer insulating layer 161, the second gate insulating layer 142, and the first gate insulating layer 141 are continuously formed at a portion where the lower layer opening OPv1 is disconnected. The first scan line 151 and light emission control line 155 are disposed in the portion where the lower layer opening OPv1 is disconnected to cross the lower layer opening OPv1. The lower layer opening OPv1 may have a structure that prevents the semiconductor layer and/or conductive layer from crossing the lower layer opening OPv1, but the metal layer BML disposed below the first gate insulating layer 141 in which the lower layer opening OPv1 is formed may be formed to cross the lower layer opening OPv1 in the second direction DR2.

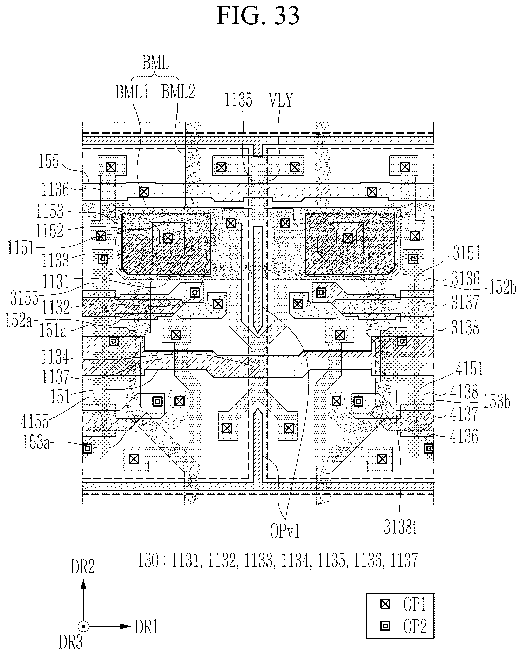

Referring to FIG. 33, a valley portion VLY is formed by filling the lower layer opening OPv1 with an organic material, and a valley portion opening may be formed where the lower layer opening OPv1 is disconnected. The organic material forming the valley portion VLY (hereinafter, also referred to as organic material for the valley) may only fill the lower layer opening OPv1 and not be disposed on a top of the second interlayer insulating layer 162 as shown in FIG. 25, and depending on embodiments, as shown in FIG. 40, the organic material forming the valley portion VLY may also be disposed on the second interlayer insulating layer 162.

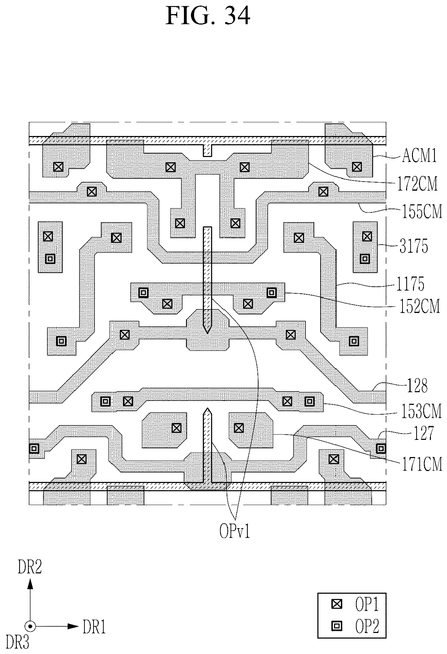

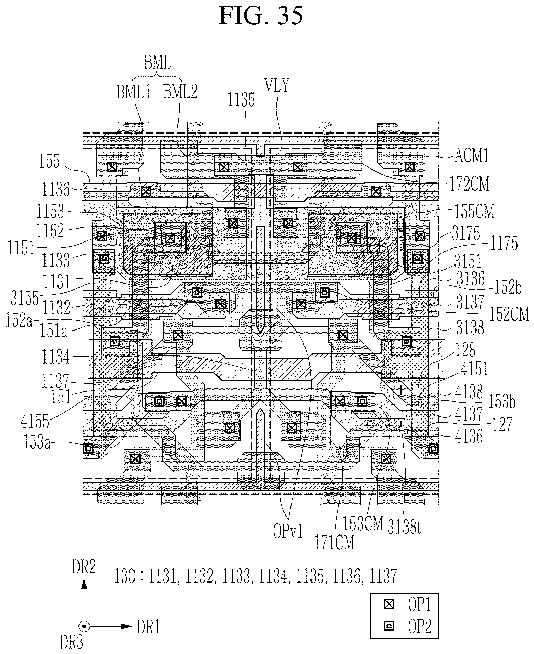

FIG. 34 and FIG. 35 illustrate a first data conductive layer, and the first data conductive layer may further include connecting electrodes 152CM, 153CM, and 155CMas compared to FIG. 11 and FIG. 12. Meanwhile, openings OP1 and OP2 may be additionally formed to connect the additional connecting electrodes 152CM, 153CM, and 155CM.

In FIG. 34 and FIG. 35, the additional connecting electrodes 152CM, 153CM, and 155CM may be provided to connect the conductive layers which are disconnected in areas corresponding to the valley portion VLY, and depending on embodiments, the connecting electrode 155CM may be omitted.

This will be described in detail hereinafter.

In FIG. 34 and FIG. 35, the connecting electrode 152CM is connected to the lower second scan line 152a through the opening OP1 and connected to the upper second scan line 152b through the opening OP2. Thus, adjacent lower second scan lines 152a and adjacent upper second scan lines 152b may be electrically connected each other through the valley portion VLY.

In FIG. 34 and FIG. 35, the connecting electrode 153CM is connected to the lower initialization control line 153a through the opening OP1 and connected to the upper initialization control line 153b through the opening OP2. Thus, adjacent lower initialization control lines 153a and adjacent upper initialization control lines 153b may be electrically connected each other through the valley portion VLY.

In FIG. 34 and FIG. 35, the connecting electrode 155CM connects the light emission control line 155 through the opening OP1. However, since the light emission control line 155 has a connected structure, the connecting electrode 155CM may be omitted depending on embodiments.

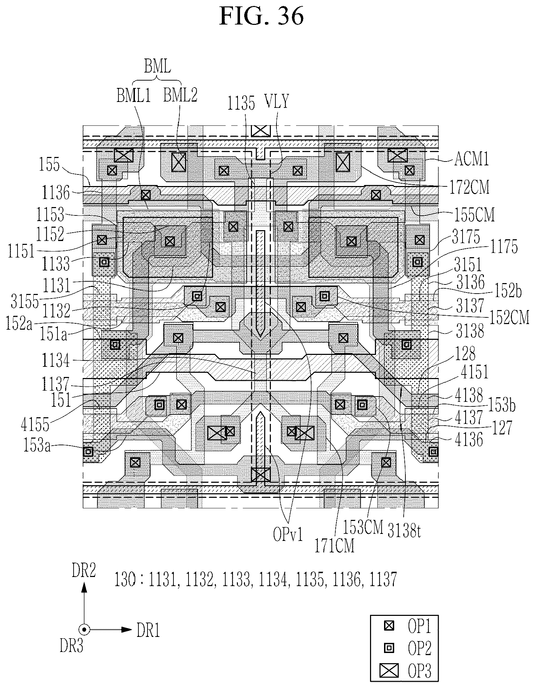

Referring to FIG. 36, a lower organic layer opening OP3 is further formed, and the lower organic layer opening OP3 overlaps connecting electrodes 171CM and 172CM and an anode connecting electrode ACM1 which are disposed on the first data conductive layer to expose them, respectively. In addition, the lower organic layer opening OP3 may overlap a first initialization voltage line 127 or a second initialization voltage line 128, and in the embodiment of FIG. 36, it overlaps with the first initialization voltage line 127.

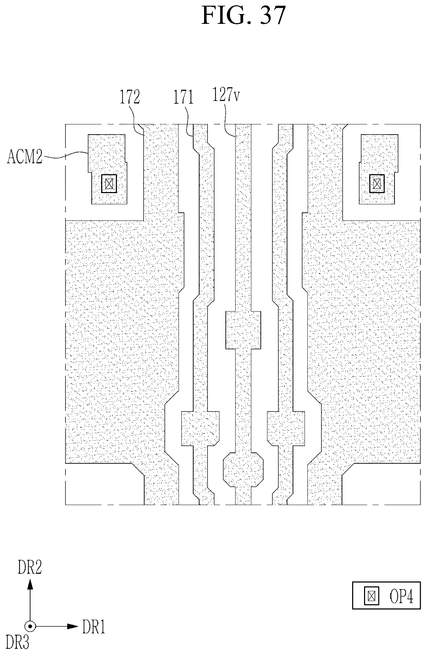

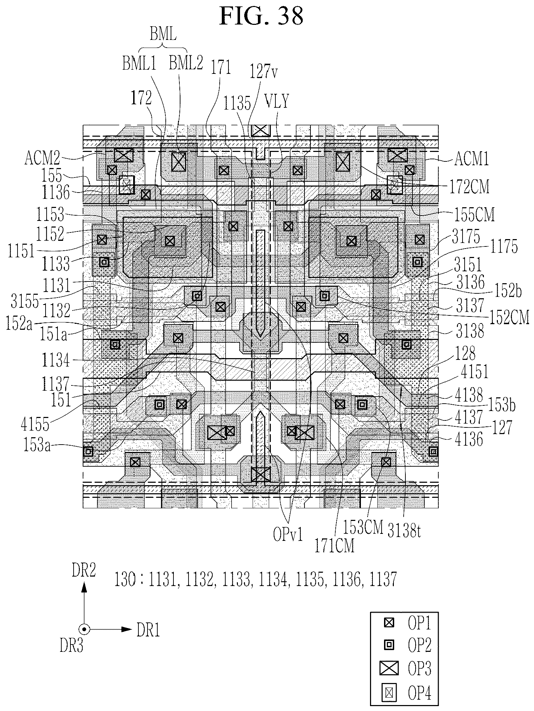

Referring to FIG. 37 and FIG. 38, the second data conductive layer may have the same structure as that of FIG. 14.

According to the embodiment of FIG. 26 to FIG. 38, some conductive layers (i.e., the lower second scan line 152a, the upper second scan line 152b, the lower initialization control line 153a, and the upper initialization control line 153b) are disconnected in areas corresponding to the second portion of the valley portion VLY, extend in the second direction DR2 such that the additional openings OP1 and OP2 and the additional connecting electrodes 152CM and 153CM are further included in the first data conductive layer to electrically connect the disconnected portions.

In the case of forming the first data conductive layer which extends to cross the upper portion of the valley portion VLY, a density of the first data conductive layer of the embodiment of FIG. 34 is greater than that compared to the embodiment of FIG. 11. However, the density of the first data conducive layer of FIG. 34 is relatively lower than that of the comparative example of FIG. 23. Therefore, compared to the comparative example, the area occupied by the pixel circuit portion PC can be reduced, and a high-resolution light emitting display device can be formed. In addition, since the valley portion VLY surrounds the pixel circuit portion PC except for some valley portion opening VLYo, it is possible to manufacture a light emitting display device having high resolution and high impact resistance.

Hereinafter, a cross-sectional structure of the light emitting display device according to each of the embodiments will be described with reference to FIG. 39 and FIG. 40.

FIG. 39 and FIG. 40 are cross-sectional views of a light emitting display device according to another embodiment.

First, in an embodiment of FIG. 39 and FIG. 40, a valley portion VLY is formed of an organic material (an organic material for the valley) and is formed in all of a second interlayer insulating layer 162, a third gate insulating layer 143, a first interlayer insulating layer 161, a second gate insulating layer 142, and a first gate insulating layer 141.

Not as shown in FIG. 16, the cross-section structure of FIG. 39 and FIG. 40 further includes connecting electrodes 152CM and 155CM. The connecting electrodes 152CM and 155CM are disposed on an upper portion of the valley portion VLY, and the connecting electrode 155CM is connected through the upper portion of the valley portion VLY.

In the embodiment of FIG. 39, an organic material forming the valley portion VLY is disposed only within the lower layer opening OPv1 and is not disposed on the second interlayer insulating layer 162.

Meanwhile, in the embodiment of FIG. 40, an organic material forming the valley portion VLY is also disposed on the second interlayer insulating layer 162.

In the embodiment of FIG. 40, an additional conductive layer may be formed under the first data conductive layer, and intermediate connecting electrodes 3175-1, 152CM-1, 155CM-1, and ACM1-1 may be further formed in the additional conductive layer. The additional conductive layer may be disposed above the second interlayer insulating layer 162 and below the organic material forming the valley portion VLY.

Here, the intermediate connecting electrode 3175-1 may assist the second connecting electrode 3175 to connect a second region 1133 of a driving transistor T1 and a first region 3136 of a third transistor T3. The intermediate connecting electrode 152CM-1 may assist the connecting electrode 152CM to electrically connect a lower second scan line 152a and an upper second scan line 152b across the valley portion VLY. The intermediate connecting electrode 155CM-1 may assist the connecting electrode 155CM to electrically connect a light emission control line 155 across the valley portion VLY. The intermediate connecting electrode ACM1-1 may assist the anode connecting electrode ACM1 to electrically connect a sixth transistor T6 and an anode Anode.

Hereinabove, a detailed pixel stacking structure of a specific light emitting display device has been described.

However, depending on embodiments, it may have a valley portion VLY of a structure different from that of FIG. 1, which will be described hereinafter with reference to FIG. 41 to FIG. 43.

FIG. 41 to FIG. 43 are top plan views of a part of a display area of a light emitting display device according to another embodiment.

FIG. 41 to FIG. 43 illustrate only two pixel circuit portions PC, and a valley portion that surrounds the two pixel circuit portions PC and includes a valley portion opening VLYo is illustrated.

Not as in FIG. 1, in FIG. 41, valley portion openings VLYo disposed on a left side of the two pixel circuit portions PC and on the right side of the two pixel circuit portions PC are not disposed in a line extending parallel to the first direction DR1. Specifically, a valley portion opening VLYo positioned at a second portion of the valley portion VLY is formed in plural, and positions of the plurality of the valley portion openings VLYo at two adjacent second portions are different from each other. On the contrary, in FIG. 1, the positions of the valley portion openings VLYo in the two adjacent second portions are disposed on a line extending along the first direction DR1.

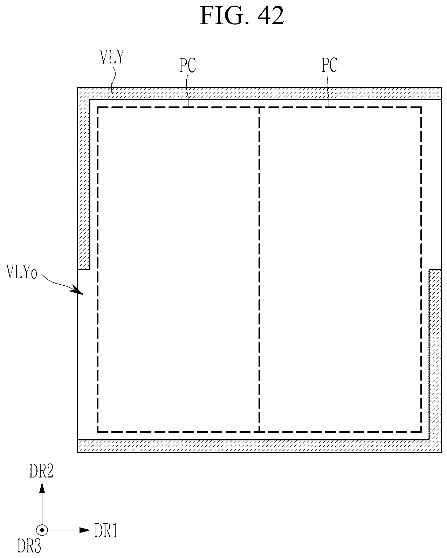

Meanwhile, in FIG. 42, a valley portion opening VLYo is formed as one and is relatively large in size. Specifically, one valley portion opening VLYo positioned in a second portion of a valley portion VLY is formed, and the positions of the valley portion openings VLYo in the two adjacent second portions different from each other. In FIG. 1 and FIG. 41, a plurality of valley portion openings VLYo are formed for every second portion extending along the second direction DR2 and the size of each valley portion opening VLYo is relatively small, and thus the structure is different from that of FIG. 42.

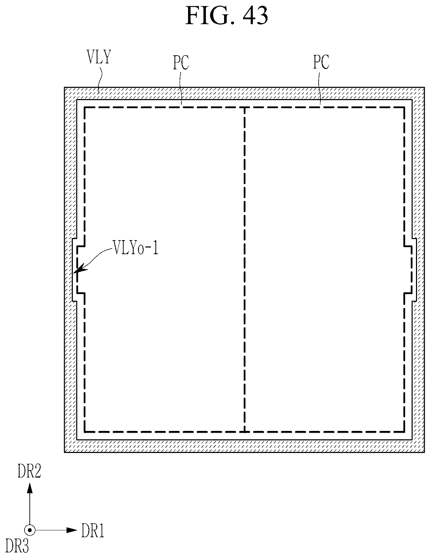

In FIG. 43, not as in FIG. 1, FIG. 41, and FIG. 42, a valley portion opening VLYo is not included, and a concavely formed groove VLYo-1 is formed. As a result, a region of a pixel circuit portion PC shown as a dotted line also has a convexly protruded structure along the groove VLYo-1.

That is, in order to overcome the drawback of forming a high-resolution pixel circuit portion PC while lacking space by forming the valley portion VLY, the width of the valley portion VLY is reduced while forming the groove VLYo-1 to thereby increase an area where the pixel circuit portion PC can be formed.

Specifically, the valley portion VLY is within the display area, divides a plurality of pixel circuit portions PC into a plurality of areas, and includes at least one concave groove VLYo-1. In this case, the pixel circuit portion PC includes a protrude portion convexly protruded along the groove VLYo-1. The valley portion VLY includes a first portion extending in a first direction and a second portion extending in a second direction, and the groove VLYo-1 may be disposed in the second portion.

The valley portion VLY may have the same structure as in the embodiment described above. That is, when a plurality of metal layers, a semiconductor layer, and a plurality of insulating layers are formed in the pixel circuit portion PC, an organic material for the valley is filled in a lower layer opening OPv1 formed by continuously removing some of the insulating layers among the plurality of insulating layers, thereby forming a valley portion VLY.

A part of a transistor or a part of a capacitor is formed in the protrude portion of the pixel circuit portion PC, and thus the transistor or capacitor included in the pixel circuit portion PC has a certain size or more and has the merit of preventing malfunction.

Therefore, the light emitting display device of the embodiment of FIG. 43 reduces the area occupied by the valley portion VLY to expand a space for the pixel circuit portion PC, thereby forming a higher resolution pixel circuit portion PC and forming a high-resolution light emitting display device. In addition, although the width of the valley portion VLY is partially reduced due to the groove VLYo-1, it surrounds the pixel circuit portion PC as a whole and has high impact resistance, and thus a light emitting display device with high resolution and high impact resistance can be manufactured.

FIG. 2 to FIG. 16 and FIG. 26 to FIG. 40 may also be applied to the embodiment of FIG. 43.

Meanwhile, depending on embodiments, the valley portion VLY may include both the groove VLYo-1 and the valley portion opening VLYo.

Although an embodiment has been described in detail above, the scope of the present invention is not limited thereto, and various modifications of a person of an ordinary skill in the art using the basic concept of the present invention defined in the following claims range and improved forms also fall within the scope of the present invention as defined by the appended claims.

## Claims

1. A light emitting display device comprising a display area (DA), the display area (DA) comprising:
a plurality of pixel circuit portions (PC),
a plurality of light emitting diodes (LED) electrically connected to the plurality of pixel circuit portions (PC), respectively, and
a valley portion (VLY) that is disposed in the display area (DA), surrounds at least one of the plurality of pixel circuit portions (PC) to partition the plurality of pixel circuit portions (PC) into a plurality of regions, and includes at least one valley portion opening (VLYo).

2. The light emitting display device of claim 1,
wherein each of the plurality of pixel circuit portions (PC) comprises a plurality of conductive layers, a semiconductor layer, and a plurality of insulating layers, and
wherein the valley portion (VLY) is a portion of the plurality of insulating layers in which at least one of the plurality of insulating layers is removed and filled with an organic material; and/or
wherein the plurality of light emitting diodes (LED) are disposed on the plurality of pixel circuit portions (PC).

3. The light emitting display device of claim 1 or 2, wherein the valley portion (VLY) comprises a first portion extending in a first direction (DR1) and a second portion extending in a second direction (DR2), and
wherein the at least one valley portion opening (VLYo) is disposed in the second portion.

4. The light emitting display device of claim 3, wherein the at least one valley portion opening (VLYo) disposed in the second portion is formed in a plurality; and
wherein at least two valley portion openings (VLYo) are disposed on a line extending along the first direction (DR1), and/or
wherein valley portion openings (VLYo) disposed adjacent to each other along the first direction (DR1) are not disposed on a line extending along the first direction (DR1) .

5. The light emitting display device of claim 3 or 4, wherein one second portion in the one region of the plurality of regions includes one valley portion opening (VLYo), and
wherein valley portion openings (VLYo) in adjacent second portions are disposed in areas different from each other along the second direction (DR2).

6. The light emitting display device of claim 1 or 2, wherein each of the plurality of pixel circuit portions (PC) comprises a plurality of wirings, a plurality of transistors, and a storage capacitor (Cst), and
wherein at least one of the plurality of wirings directly connecting adjacent pixel circuit portions (PC) is connected through the at least one valley portion opening (VLYo).

7. The light emitting display device of claim 6, wherein the plurality of transistors included in the each of the plurality of pixel circuit portions (PC) comprise a first transistor (T1), a second transistor (T2), a third transistor(T3), a fourth transistor (T4), a fifth transistor (T5), and a sixth transistor(T6),
wherein the plurality of wirings comprise:
a first scan line (151) connected to a gate electrode of the second transistor (T2);
a second scan line (152) connected to a gate electrode of the third transistor (T3);
an initialization control line (153) connected to a gate electrode of the fourth transistor (T4); and
a light emission control line (155) connected to a gate electrode of the fifth transistor (T5) and a gate electrode of the sixth transistor (T6), and
wherein the at least one of the plurality of wirings directly connecting the adjacent pixel circuit portions (PC) through the at least one valley portion opening (VLYo) is one of the first scan line (151), the second scan line (152), the initialization control line (153), and the light emission control line (155).

8. The light emitting display device of claim 7, wherein the valley portion (VLY) comprises a first portion extending in a first direction (DR1) and a second portion extending in a second direction (DR2),
wherein the at least one valley portion opening (VLYo) is formed in plurality in the second portion, and
wherein a valley portion opening (VLYo) through which first scan lines (151) disposed adjacent to each other along the first direction (DR1) is connected is different from a valley portion opening (VLYo) through which light emission control lines (155) disposed adjacent to each other along the first direction (DR1) is connected.

9. The light emitting display device of claim 8, wherein the second portion of the valley portion (VLY) further comprises valley portion openings (VLYo) through which second scan lines (152) disposed adjacent to each other along the first direction (DR1) and initialization control lines (153) disposed adjacent to each other along the first direction (DR1) are connected, respectively.

10. The light emitting display device of any one of claims 7 to 9, wh erein the second scan line (152) further comprises a lower second scan line (152 a) connected to the second scan line (152) and the initialization control line (153 ) further comprises a lower initialization control line (153a) electrically connected to the initialization control line (153), and
wherein the lower second scan line (152a) and the lower initialization control line (153a) are also directly connected through the same valley portion opening (VLYo) with the second scan line (152) and the initialization control line (153), respectively.

11. The light emitting display device of any one of claims 7 to 10, w herein the first transistor (T1), the second transistor (T2), the fifth transistor (T3) , and the sixth transistor (T6) comprise a polycrystalline semiconductor (P-Si), an d
wherein the third transistor (T3) and the fourth transistor (T4) comprise an oxide semiconductor.

12. The light emitting display device of claim 11, wherein the polycry stalline semiconductor (P-Si) included in the first transistor (T1), the second trans istor (T2), the fifth transistor (T5), and the sixth transistor (T6) is formed as a f irst semiconductor layer (130), and
wherein the first semiconductor layer (130) comprises a portion (1134, 1135) formed in common with an adjacent first semiconductor layer (130).

13. The light emitting display device of claim 12, wherein
the portion (1134, 1135) formed in common among the first semiconductor layer (130) overlaps with the valley portion (VLY) in a plan view.

14. The light emitting display device of any one of claims 7 to 13, further comprising a metal layer (BML) that is provided in a lower portion of the first transistor (T1) and overlaps a channel (1131) of the first transistor (T1),
wherein the metal layer (BML) extends while overlapping the valley portion (VLY).

15. A light emitting display device comprising a display area (DA), the display area (DA) comprising:
a plurality of pixel circuit portions (PC),
a plurality of light emitting diodes (LED) electrically connected to the plurality of pixel circuit portions (PC), respectively, and
a valley portion (VLY) that is disposed in the display area (DA), surrounds at least one of the plurality of pixel circuit portions (PC) to partition the plurality of pixel circuit portions (PC) into a plurality of regions, and includes at least one concave groove (VLYo-1) having a width narrower than other portions of the valley portion (VLY), and
wherein the pixel circuit portion (PC) is convexly protruded along the groove (VLYo-1).

16. The light emitting display device of claim 15,
wherein the pixel circuit portion (PC) comprises a plurality of conductive layers, a semiconductor layer, and a plurality of insulating layers, and
wherein the valley portion (VLY) is a portion of the plurality of insulating layers in which at least one of the plurality of insulating layers is removed and filled with an organic material; and/or
wherein the valley portion (VLY) comprises a first portion extending in a first direction (DR1) and a second portion extending in a second direction (DR2), and
wherein the groove (VLYo-1) is disposed in the second portion.

17. The light emitting display device of claim 15 or 16, wherein the pixel circuit portion (PC) comprises a plurality of wirings, a plurality of transistors, and a storage capacitor (Cst), and
wherein the pixel circuit portion (PC) comprises a protrude portion convexly protruding along the groove (VLYo-1), and
wherein a portion of at least one of the plurality of transistors or the storage capacitor (Cst) is disposed in the protrude portion.
